# EUROPÄISCHE PATENTSCHRIFT

(11) **EP 4 615 793 B1**
(45) Veröffentlichungstag und Bekanntmachung des Hinweises auf die Patenterteilung: **21.10.2026**
(21) Anmeldenummer: 23801743.8
(22) Anmeldetag: 06.11.2023
(51) Int. Cl.: B81B 7/00

(54) **SCHALTUNG MIT AUFWÄRTSWANDLER ZUR ANSTEUERUNG EINES AKTUATORS ZUM ANTRIEB EINER SCHWINGUNGSBEWEGUNG IN EINEM MEMS**
CIRCUIT COMPRISING A STEP-UP CONVERTER FOR CONTROLLING AN ACTUATOR FOR DRIVING AN OSCILLATING MOVEMENT IN AN MEMS
CIRCUIT COMPRENANT UN CONVERTISSEUR ÉLÉVATEUR DE TENSION POUR COMMANDER UN ACTIONNEUR POUR L'ENTRAÎNEMENT D'UN MOUVEMENT D'OSCILLATION DANS UN MEMS

(30) Priorität: 07.11.2022 DE 102022129371
(43) Veröffentlichungstag der Anmeldung: 17.09.2025
(73) Patentinhaber: OQmented GmbH, 25524 Itzehoe (DE)
(72) Erfinder: GALJAN, Wjatscheslaw, 24568 Nützen (DE); POHL, Leon, 24223 Schwentinental (DE); MEOLA, Marco, 24105 Kiel (DE)
(74) Vertreter: Platzöder Patentanwaltsgesellschaft mbH
(86) Internationale Anmeldenummer: PCT/EP2023/080863
(87) Internationale Veröffentlichungsnummer: WO 2024/099980

(56) Entgegenhaltungen:
- WO-A1-2022/008864

## Beschreibung

Die vorliegende Erfindung betrifft eine Schaltung zur Ansteuerung eines Aktuators, insbesondere eines MEMS-Aktuators, zum Antrieb einer Schwingungsbewegung in einem mikro-elektromechanischen System (MEMS), sowie ein damit ausgestattetes MEMS. Die Schaltung weist zumindest einen Aufwärtswandler, insbesondere Hochsetzsteller zur Bereitstellung einer elektrischen Versorgung für den Antrieb der Schwingungsbewegung auf. Das MEMS kann insbesondere ein Mikroscannersystem mit einem schwingungsfähig angeordneten Ablenkelement (Spiegel) sein, wobei der Aktuator zum Antrieb einer Schwingungsbewegung (Oszillation) des Ablenkelements eingerichtet ist.

Viele MEMS, d.h. Systeme mit mehreren Komponenten, deren Ausmaße typischerweise im Bereich von 1 µm bis 100 µm liegen, wobei die MEMS selbst typischerweise jeweils Ausmaße im Bereich von etwa 10 µm bis zu wenigen Millimetern aufweisen, verfügen über bewegliche mechanische Teile, die unter Nutzung elektrischer Energie antreibbar sind, so dass eine mikroskopisch kleine Maschine als elektromechanisches System vorliegt.

Schwingungsfähig angeordnete Massenelemente von MEMS, insbesondere Ablenkelemente von Mikroscannern, können auf verschiedene Art und Weise zum Schwingen gebracht werden. Dafür ist jedoch stets eine antreibende Kraft erforderlich, welche in der Lage ist, das Ablenkelement (z.B. Spiegelplatte) aus seiner Ruhelage auszulenken. Als eine derartige Kraft liefernde Antriebe für MEMS (insbesondere kleine Mikrophone, Lautsprecher oder Gyroskope, Mikroscanner oder mehrere Mikroscanner aufweisende Mikroscannersysteme) werden typischerweise ein oder mehrere Aktuatoren eingesetzt, die nach einem elektrostatischen, elektromagnetischen, piezoelektrischen, thermischen oder einem anderen Aktuatorprinzip oder nach einer Mischform von zwei oder mehr solcher Aktuatorprinzipien betrieben werden.

Unter dem Begriff "MEMS-Aktuator", wie hierin verwendet, ist insbesondere ein Aktuator zu verstehen, der elektrische und/oder magnetische Energie in mechanische Energie wandeln kann, und/oder umgekehrt, und sich dazu eines MEMS bedient oder selbst ein Bestandteil davon ist, insbesondere als dieses selbst oder als Komponente davon. Ein solcher MEMS-Aktuator kann insbesondere so ausgebildet sein, dass er auf Basis des direkten oder inversen piezoelektrischen Effekts arbeitet. Soweit hierin auf einen "Aktuator" Bezug genommen wird, kann dieser stets insbesondere ein MEMS-Aktuator sein.

Bei Mikroscannern, die in der Fachsprache insbesondere auch als "MEMS-Scanner", "MEMS-Spiegel" oder auch "Mikrospiegel" oder im Englischen insbesondere als "microscanner" bzw. "micro-scanning mirror" oder "MEMS mirror" bezeichnet werden, handelt es sich speziell um MEMS oder genauer um mikro-opto-elektro-mechanische Systeme (MOEMS) aus der Klasse der Mikrospiegelaktoren zur dynamischen Modulation von elektromagnetischer Strahlung, insbesondere von sichtbarem Licht. Je nach Bauart kann die modulierend wirkende Bewegung eines Einzelspiegels translatorisch oder um zumindest eine Achse rotatorisch erfolgen. Im ersten Fall wird eine phasenschiebende Wirkung, im zweiten Fall die Ablenkung der einfallenden elektromagnetischen Strahlung erzielt. Im Weiteren werden Mikroscanner betrachtet, bei denen die modulierend wirkende Bewegung eines Einzelspiegels, zumindest auch, rotatorisch erfolgt. In Abgrenzung zu Spiegelarrays, bei denen die Modulation von einfallendem Licht über das Zusammenwirken einer Vielzahl von einzelnen kleinen Spiegeln auf einem einzigen MEMS-Bauelement erfolgt, wird die Modulation bei Mikroscannern typischerweise über einen einzelnen Spiegel je MEMS-Bauelement (Mikroscanner) erzeugt.

Mikroscanner können somit insbesondere zur Ablenkung von elektromagnetischer Strahlung eingesetzt werden, um mittels eines Ablenkelements ("Spiegel") einen darauf einfallenden elektromagnetischen Strahl bezüglich seiner Ablenkrichtung zu modulieren. Das kann insbesondere dafür genutzt werden, eine Lissajous-Projektion des Strahls in ein Beobachtungsfeld bzw. Projektionsfeld zu bewirken. So lassen sich beispielsweise bildgebende sensorische Aufgaben lösen oder auch Display-Funktionalitäten realisieren. Darüber hinaus können solche Mikroscanner auch dazu eingesetzt werden, Materialien in vorteilhafter Weise zu bestrahlen, insbesondere zu deren Bearbeitung. Mögliche andere Anwendungen liegen im Bereich der Beleuchtung oder Ausleuchtung bestimmter offener oder geschlossener Räume oder Raumbereiche mit elektromagnetischer Strahlung, beispielsweise im Rahmen von Scheinwerferanwendungen.

In vielen Fällen weisen Mikroscanner als Ablenkelement eine Spiegelplatte ("Spiegel") auf, die seitlich an elastisch dehnbaren Federn aufgehängt ist. Man unterscheidet einachsige Spiegel, die vorzugsweise nur um eine einzige Achse drehbar aufgehängt sein sollen, von zweiachsigen und mehrachsigen Spiegeln, bei denen Rotationen, insbesondere rotatorische Schwingungsbewegungen, um eine entsprechende Anzahl verschiedener Achsen möglich sind, insbesondere simultan.

Ein Mikroscannersystem zum Ablenken eines elektromagnetischen Strahls kann somit insbesondere einen zweiachsigen Mikroscanner, also einen Mikroscanner mit zwei verschiedenen nicht-parallelen, insbesondere zueinander orthogonalen, Schwingungsachsen oder eine Kombination von mehreren einzelnen, insbesondere zwei, einachsigen Mikroscannern aufweisen, die so angeordnet sind, dass der einfallende Strahl nacheinander durch die verschiedenen einzelnen Mikroscanner des Mikroscannersystems abgelenkt werden kann um ein zweidimensionales Ablenkungsmuster, insbesondere eine Lissajous-Figur, zu erzeugen. Bei einem Mikroscannersystem mit einer Kombination aus zwei oder drei einachsigen Mikroscannern können deren nicht-parallele Schwingungsachsen insbesondere paarweise orthogonal zueinander liegen.

Speziell bei sogenannten Lissajous-Mikroscannern bzw. Lissajous-Mikroscannersystemen, werden zwei nicht-parallele, insbesondere zueinander orthogonale Schwingungsachsen simultan, insbesondere in Resonanz, betrieben, um dabei eine Trajektorie der vom Ablenkelement abgelenkten Strahlung in Form einer Lissajous-Figur zu erzeugen. Auf diese Weise lassen sich in beiden Achsen große Amplituden erreichen.

Aus der EP 2 514 211 B1 ist eine solche Ablenkeinrichtung für ein Projektionssystem zum Projizieren von Lissajous-Figuren auf ein Beobachtungsfeld bekannt, die ausgebildet ist, einen Lichtstrahl, insbesondere Laserstrahl, um mindestens eine erste und eine zweite Ablenkachse zur Erzeugung von Lissajous-Figuren umzulenken.

WO 2022/008864 A1 beschreibt eine Treiberschaltung zum Ansteuern eines kapazitiven Wandlers, beispielsweise eines piezoelektrischen Wandlers oder eines elektrostatischen Wandlers. Die Schaltung umfasst: eine Stromversorgung; eine Speicherkapazität; eine Schaltnetzwerkschaltung; und eine Steuerschaltung. Die Steuerschaltung ist so konfiguriert, dass sie den Betrieb der Schaltnetzwerkschaltung so steuert, dass die Speicherkapazität aus der Stromversorgung geladen wird und Ladung zwischen der Speicherkapazität und dem kapazitiven Wandler übertragen wird.

Als Antriebe für MEMS, wie insbesondere kleine Mikrophone, Lautsprecher oder Gyroskope, und insbesondere auch für Mikroscanner bzw. Mikroscannersysteme werden typischerweise elektrostatische, elektromagnetische, piezoelektrische, thermische und andere Aktuatorprinzipien eingesetzt. Speziell bei piezoelektrischen Aktuatoren ("Piezoaktor") wird dabei ein piezoelektrisches Material in einem durch eine (elektrische) Kapazität erzeugtes elektrisches Feld unter Nutzung des inversen Piezoelektrischen Effekts in Abhängigkeit von der Stärke des Felds verformt. Ist das Feld zeitlich variabel, insbesondere aufgrund eine an der Kapazität anliegenden variablen Spannung, so ergibt sich in der Folge eine durch die Feldvariation steuerbare variable Verformung des Piezomaterials die als kleiner Motor zum Antrieb einer mechanischen Bewegung, speziell bei Mikroscannern einer Schwingungsbewegung des Spiegels, genutzt werden kann.

Insbesondere bei resonant betriebenen, schwingungsfähigen MEMS-Komponenten, wie etwa dem Ablenkelement bei einem Mikroscanner, sind der bzw. die Aktuatoren oftmals jedoch insgesamt nicht stark genug, um die schwingungsfähigen MEMS-Komponente im Rahmen einer einzigen Aktivierung des Aktuators bzw. der Aktuatoren bis hin zu einer im Betrieb angestrebten Zielamplitude statisch auszulenken. Um trotzdem die Zielauslenkung zu erreichen, muss daher der zumindest eine Aktuator, im Falle eines Piezoaktuators dessen piezoelektrische Material, mit einer periodischen Wechselspannung beaufschlagt werden, deren Frequenz zumindest in guter Näherung, idealerweise genau der mechanischen Resonanzfrequenz der schwingungsfähigen MEMS-Komponente entspricht. Daraus resultieren dann kleine aber immer zum richtigen Zeitpunkt auftretende Antriebskräfte, die nach einer gewissen Zeit in der Lage sind, den durch die schwingungsfähige MEMS-Komponente nebst ihrer Aufhängung oder Lagerung gebildeten mechanischen Oszillator signifikant aufzuschwingen und somit nach und nach mit mechanischer Energie "aufzuladen", bis die Zielamplitude erreicht ist (und ggf. über einen längeren Zeitraum auch gehalten werden kann).

Aus elektrischer Sicht entspricht dieser Antriebsvorgang bei einem kapazitiven Aktuator, insbesondere einem Piezoaktor, einem ständigen Umladen seines Kondensators. Speziell im Falle eines Mikroscanners mit piezoelektrischem Antrieb beeinflusst die Amplitude der Wechselspannung über dem Kondensator des Piezoaktors wesentlich den sich einstellenden bzw. im eingeschwungenen Zustand maximal erreichbaren Scanwinkel (Zielamplitude) des Mikroscanners.

Insbesondere dann, wenn ein MEMS in einem Gerät zum Einsatz kommen soll, dem nur eine eng begrenzte elektrische Energiemenge oder elektrische Leistung zur Energieversorgung im Betrieb zur Verfügung steht, wie dies etwa bei einem batteriebetriebenen, insbesondere tragbaren Gerät (etwa bei einem mobilen, insbesondere portablen Endgerät, z.B. Smartphone, oder einem sog. "Wearable", oder einer AR/VR-Brille oder einem in Kleidung integrierten MEMS) meist der Fall ist, sind energieeffiziente Antriebe für die MEMS vorteilhaft oder gar notwendig, um eine möglichst lange, insbesondere eine applikationsbezogen ausreichend lange autarke Nutzungsdauer der Geräte zu ermöglichen.

Zur Reduktion der Leistungsaufnahme der MEMS ist es daher erstrebenswert, die Umladevorgänge am Kondensator des Aktuators so effizient wie möglich zu gestalten. So kann die resultierende Gesamt-Leistungsaufnahme für den Antrieb des MEMS minimiert und insbesondere die Lebensdauer der Batterie(en) bzw. des/der Akkus erhöht werden.

Oftmals liegt zudem das dem Gerät zur Verfügung stehende Spannungsniveau, insbesondere eine Batteriespannung, unterhalb eines von dem Aktuator benötigten Spannungsniveau, so dass eine Spannungswandlung benötigt wird, um es zu erreichen. Es ist eine Aufgabe der vorliegenden Erfindung, eine verbesserte Schaltung zur Ansteuerung eines Aktuators zum energieeffizienten und/oder platzsparenden Antrieb einer Schwingungsbewegung in einem MEMS sowie ein mit einer solchen Schaltung ausgestattetes MEMS, insbesondere Mikroscannersystem, anzugeben.

Diese Aufgabe wird durch die Schaltung gemäß Anspruch 1 gelöst.

Verschiedene Ausführungsformen und Weiterbildungen der Erfindung sind Gegenstand der Unteransprüche und/oder der nachfolgenden Beschreibung, die der besseren Übersichtlichkeit halber in jeweils von einer Überschrift eingeleitete Abschnitte strukturiert ist, die jedoch nicht als inhaltliche Beschränkung der unter sie fallenden Textabschnitte oder darin beschriebener Figuren aufzufassen ist.

### Begrifflichkeiten

Unter dem Begriff "MEMS-Kapazität", wie hierin verwendet, ist eine elektrische Kapazität, insbesondere ein einzelner elektrischer Kondensator, zu verstehen, die bzw. der zumindest anteilig als ein Bestandteil eines MEMS-Aktuators ausgebildet und konfiguriert ist, für den Betrieb des Aktuators eingesetzte elektrische Energie für deren (anteilige) Wandlung in mechanische Energie zumindest temporär zu speichern. Insbesondere kann eine solche MEMS-Kapazität einen Kondensator, insbesondere Plattenkondensator, eines Piezoaktors mit einem piezoelektrischen Material als Dielektrikum aufweisen. Eine MEMS-Kapazität kann insbesondere als integriertes Bauelement eines MEMS ausgebildet sein, insbesondere so, dass die Elektroden und das Dielektrikum der MEMS-Kapazität jeweils als eine Schicht einer in oder auf einem Halbleitersubstrat erzeugten Schichtfolge bilden.

Unter dem Begriff "Steuerung", wie hierin verwendet, ist insbesondere ein Vorgang oder eine zum Ausführen eines solchen Vorgang konfigurierte Vorrichtung (Steuerungseinrichtung) zu verstehen, der bzw. die eingerichtet ist, eine oder mehrere Komponenten einer Schaltung, darunter insbesondere eine oder mehrere von deren Schalteinrichtungen, im Sinne einer Steuerung (engl. "open-loop") oder Regelung (engl. "closed-loop") über entsprechende Signale anzusteuern. Sie kann insbesondere einen computerprogrammgesteuerten Mikrocontroller oder eine festverdrahtete Steuerschaltung sein oder aufweisen. Eine solche Steuerungseinrichtung kann insbesondere selbst Teil der Schaltung sein.

Unter dem Begriff "Hochsetzstellerschaltung" (engl. "Boost-Converter" oder "Step-Up-Converter"), wie hierin verwendet, ist eine Form eines Gleichspannungswandlers zu verstehen, der konfiguriert ist bei der Wandlung eine Eingangsspannung derart in eine Ausgangsspannung zu wandeln, dass Betrag der Ausgangsspannung größer ist als der Betrag der Eingangsspannung. Der Begriff ist nicht auf eine bestimmte Topologie oder Art eines solchen Gleichspannungswandlers beschränkt.

Unter dem Begriff "Schalteinrichtung", wie hierin verwendet, ist eine Schaltung oder Komponente davon zu verstehen, die zumindest eine als Schalter wirkende Schaltung oder Komponente ist bzw. aufweist. Insbesondere kann die Schalteinrichtung einen oder mehrere Schalter aufweisen. Sie kann insbesondere mittels eines oder mehrere Halbleiterbauelemente wie z.B. Transistoren oder Dioden implementiert sein. Beispielsweise kann ein einzelner Transistor oder ein CMOS-Gate bei entsprechender Ansteuerung als Schalter wirken. Auch eine Diode kann, insbesondere in Vorwärtsrichtung, als Schalter wirken, wenn eine über ihr anliegende Spannung wahlweise oberhalb ihrer Schwellspannung (in Durchlassrichtung) oder unterhalb ihrer Durchbruchspannung (in Sperrrichtung,) liegt.

Unter dem Begriff "kapazitiv-ungepuffert", wie hierin verwendet, ist in Bezug auf einen Strompfad zu verstehen, dass dieser Strompfad nicht über eine Kapazität im Sinne eines Spannungspuffers, insbesondere nicht im Sinne eines Pufferkondensators, gepuffert ist. Es liegt somit (von etwaigen parasitären Kapazitäten abgesehen) kein kapazitives Bauelement (insbesondere Kondensator) zur Pufferung (d.h. Stützung) der Eingangsspannung bzw. des Eingangsstroms des über den Strompfad angesteuerten Bauelements oder Schaltungsteils, insbesondere des Aktuators, vor. Insbesondere kann eine etwaige verbleibende parasitäre Kapazität des Strompfads im Bereich von kleiner oder gleich 40 pF, insbesondere kleiner oder gleich 10 pF liegen.

Unter dem Begriff "Stromquelle", wie hierin verwendet, ist einen aktiver Zweipol zu verstehen, der an seinen Anschlusspunkten einen elektrischen Strom liefert. Als wesentliche Eigenschaft hängt die Stärke dieses Stroms nur gering ("reale" Stromquelle) oder gar nicht ("ideale" Stromquelle) von der elektrischen Spannung an seinen Anschlusspunkten ab.

Unter dem Begriff "eine auf einen dauerhaft geschlossenen Zustand des Schwingkreises bezogene Resonanzfrequenz", wie hierin verwendet, ist eine Resonanzfrequenz des Schwingkreises zu verstehen, die dieser im eingeschwungenen Zustand aufweist, wenn er dauerhaft, d.h. zumindest über den Einschwingvorgang hinaus, durchgängig geschlossen ist, d.h. insbesondere nicht durch die erste Schalteinrichtung unterbrochen ist. Bei einem idealen Schwingkreis (d.h. wenn ohmsche Widerstände R vernachlässigbar klein sind, beträgt die Resonanzfrequenz *f*₀: ${f}_{0} = \frac{1}{2 π \sqrt{LC}}$ (1) wobei C die Kapazität und L die Induktivität des Schwingkreises sind. Beim realen Schwingkreis ist die Resonanzfrequenz aufgrund der ohmschen Verluste in den Widerständen R je nach Stärke dieser Dämpfung niedriger.

Unter dem Begriff "Aufwärtswandler", wie hierin verwendet, ist ein Spannungswandler beliebiger Art und/oder Topologie zu verstehen, der aus einer Eingangsspannung per Spannungswandlung eine Ausgangsspannung erzeugt bzw. in zumindest einem Betriebsmodus erzeugen kann, sodass der Betrag der Ausgangsspannung größer ist als der Betrag der Eingangsspannung. Ein Aufwärtswandler kann zu diesem Zweck insbesondere einen oder mehrere Hochsetzsteller und/oder eine oder mehrere Ladungspumpen aufweisen.

Die hierein gegebenenfalls verwendeten Begriffe "umfasst", "beinhaltet", "schließt ein", "weist auf", "hat", "mit", oder jede andere Variante davon sollen eine nicht ausschließliche Einbeziehung abdecken. So ist beispielsweise ein Verfahren oder eine Vorrichtung, die eine Liste von Elementen umfasst oder aufweist, nicht notwendigerweise auf diese Elemente beschränkt, sondern kann andere Elemente einschließen, die nicht ausdrücklich aufgeführt sind oder die einem solchen Verfahren oder einer solchen Vorrichtung inhärent sind.

Ferner bezieht sich "oder", sofern nicht ausdrücklich das Gegenteil angegeben ist, auf ein inklusives oder und nicht auf ein exklusives "oder". Zum Beispiel wird eine Bedingung A oder B durch eine der folgenden Bedingungen erfüllt: A ist wahr (oder vorhanden) und B ist falsch (oder nicht vorhanden), A ist falsch (oder nicht vorhanden) und B ist wahr (oder vorhanden), und sowohl A als auch B sind wahr (oder vorhanden).

Die Begriffe "ein" oder "eine", wie sie hier verwendet werden, sind im Sinne von "ein/eine oder mehrere" definiert. Die Begriffe "ein anderer" und "ein weiterer" sowie jede andere Variante davon sind im Sinne von "zumindest ein Weiterer" zu verstehen.

Unter dem Begriff "konfiguriert" oder "eingerichtet" eine bestimmte Funktion zu erfüllen, (und jeweiligen Abwandlungen davon), wie er hier gegebenenfalls verwendet wird, ist zu verstehen, dass eine diesbezügliche Vorrichtung oder Komponente davon bereits in einer Ausgestaltung oder Einstellung vorliegt, in der sie die Funktion ausführen kann oder sie zumindest so einstellbar - d.h. konfigurierbar - ist, dass sie nach entsprechender Einstellung die Funktion ausführen kann. Die Konfiguration kann dabei beispielsweise über eine entsprechende Einstellung von Parametern eines Prozessablaufs oder von Schaltern oder ähnlichem zur Aktivierung bzw. Deaktivierung von Funktionalitäten bzw. Einstellungen erfolgen. Insbesondere kann die Vorrichtung mehrere vorbestimmte Konfigurationen oder Betriebsmodi aufweisen, so dass das Konfigurieren mittels einer Auswahl einer dieser Konfigurationen bzw. Betriebsmodi erfolgen kann.

Die Begriffe "erste/r/s", "zweite/r/s", "dritte/r/s" und ähnliche Begriffe in der Beschreibung und in den Ansprüchen werden zur Unterscheidung zwischen ähnlichen bzw. ansonsten gleich benannten Elementen und nicht unbedingt zur Beschreibung einer sequenziellen, räumlichen oder chronologischen Reihenfolge verwendet. Es versteht sich, dass die so verwendeten Begriffe unter geeigneten Umständen austauschbar sind und dass die hierin beschriebenen Ausführungsformen auch in anderen als den hier beschriebenen oder dargestellten Reihenfolgen funktionieren können.

### Schaltung mit Hochsetzsteller ("erste Schaltung")

Ein erster Aspekt der hier vorgestellten Lösung betrifft eine erste Schaltung zur Ansteuerung eines Aktuators, insbesondere MEMS-Aktuators, zum Antrieb einer Schwingungsbewegung zumindest einer beweglichen Komponente eines mikro-elektromechanischen Systems, MEMS. Die erste Schaltung kann insbesondere zur Ansteuerung eines Aktuators zum Antrieb einer Spiegelbewegung in einem Mikroscannersystem eingesetzt werden.

Sie weist eine Hochsetzstellerschaltung mit einer Induktivität (nachfolgend zur Unterscheidung von anderen im weiteren genannten Induktivitäten als "Booster-Induktivität" bezeichnet, insbesondere eine oder mehrere Spulen aufweisend), eine elektrische MEMS-Kapazität und eine mittels einer Steuerung ansteuerbare Schalteinrichtung auf. Die MEMS-Kapazität ist derart als Bestandteil eines Aktuators ausgebildet, dass sie einen Bestandteil eines elektro-mechanischen Wandlers des Aktuators bildet, wobei der Wandler konfiguriert ist, in der M EMS-Kapazität gespeicherte elektrische Energie in zumindest eine mechanische Größe zum Antrieb einer Bewegung des Aktuators (insbesondere zumindest einer Komponente davon) zu wandeln. Die Schalteinrichtung ist eingerichtet, in Abhängigkeit von der Steuerung eine erste Schaltungskonfiguration und sequenziell nachfolgend, insbesondere mit der ersten Schaltungskonfiguration mehrfach alternierend, eine zweite Schaltungskonfiguration einzunehmen. Dabei ist (i) in der ersten Schaltungskonfiguration ein erster Strompfad durch die Booster-Induktivität durchgängig geschaltet, um einen von einer Versorgungsspannung gespeisten ansteigenden Stromfluss durch die Booster-Induktivität zu bewirken, und (ii) in der zweiten Schaltungskonfiguration ein (von möglichen parasitären Kapazitäten abgesehen) kapazitiv-ungepufferter zweiter Strompfad zwischen einem ersten Pol der Booster-Induktivität und der MEMS-Kapazität durchgängig geschaltet, um die MEMS-Kapazität mittels eines zumindest anteilig durch die Booster-Induktivität (insbesondere als Stromquelle) gespeisten Stromflusses auf eine erste Spannung aufzuladen, die betragsweise gleich oder höher ist als die Versorgungsspannung.

Die Versorgungsspannung kann insbesondere von der Schaltung selbst erzeugbar oder dieser von extern zuführbar sein.

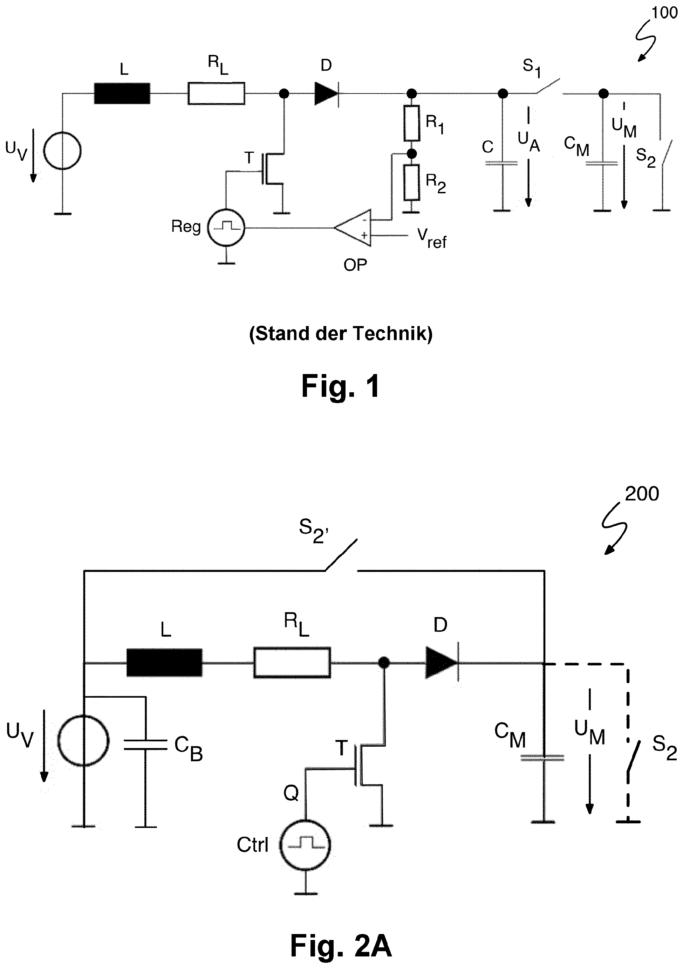

Bei der ersten Schaltung steht die über den zweiten Strompfad zwischen einem ersten Pol der Booster-Induktivität und der MEMS-Kapazität gelieferte elektrische Energie weitgehend unvermindert zur Verfügung, um die MEMS-Kapazität des Aktuators und damit dessen Funktion mittels eines zumindest anteilig durch die Booster-Induktivität gespeisten Stromflusses auf einem gegenüber der Versorgungsspannung hochgesetzten Spannungsniveau zu laden und damit zu versorgen. Das bei herkömmlichen Hochsetzstellern (vgl. Fig. 1 und Figurenbeschreibung dazu) auftretende sog. "Kondensator-Paradoxon" oder "Zwei-Kondensatoren-Paradoxon", welches dort den Wirkungsgrad schon theoretisch auf maximal 50% begrenzt (vgl. https://en.wikipedia.org/wiki/Two capacitor paradox), kann hier vermieden werden, da hier keine Konstellation mit zwei über einen Schalter parallel schaltbaren Kapazitäten im Spannungsverstärkungspfad des Hochsetzstellers erforderlich sind.

Auf diese Weise ergibt sich bei der ersten Schaltung eine deutlich reduzierte elektrische Leistungsanforderung für die Ansteuerung des Aktuators, so dass die erste Schaltung einschließlich des Aktuators insbesondere auch in Geräten zum Einsatz kommen kann, denen nur eine eng begrenzte elektrische Energiemenge oder elektrische Leistung zur Energieversorgung im Betrieb zur Verfügung steht.

Zudem ist die Schalteinrichtung eingerichtet, insbesondere in Abhängigkeit von der Steuerung, wiederholt und jeweils temporär in einem Zeitraum, in dem der zweite Strompfad nicht durchgängig geschaltet ist, einen vierten Strompfad zwischen der MEMS-Kapazität und einem zum dem ersten Pol elektrisch gegenpoligen zweiten Pol der Booster-Induktivität derart herzustellen, dass die MEMS-Kapazität dabei auf eine zweite Spannung mit einer zur Polarität der ersten Spannung entgegengesetzten Polarität aufgeladen wird. Auf diese Weise lässt sich ein bipolarer Betrieb ermöglichen, bei dem sich die Polarität über der MEMS-Kapazität ändert, insbesondere alternierend. Dementsprechend können bei Verwendung eines Aktuators, wie etwa eines Piezoaktors, der polarisationsabhängig arbeitet, verschiedene Aktuatorzustände in Abhängigkeit von, insbesondere im zeitlichen Einklang mit, dem Wechsel der Polarität der Spannung über der MEMS-Kapazität bewirkt werden. Durch einen solchen bipolaren Antrieb mit positiven und negativen Spannungen kann insbesondere zudem - im Vergleich zu einem unipolarem Antrieb - unter Nutzung lediglich einer positiven und einer negativen Spannung die Leistungsaufnahme erneut halbiert werden, wenn die gleiche Spannungsamplitude (Vₘₐₓ - Vₘᵢₙ) betrachtet wird.

Nachfolgend werden zunächst verschiedene beispielhafte Ausführungsformen der ersten Schaltung beschrieben, die jeweils, soweit dies nicht ausdrücklich ausgeschlossen wird oder technisch unmöglich ist, beliebig miteinander sowie mit den im weiteren beschriebenen anderen Aspekten der vorliegenden Lösung kombiniert werden können.

Bei einigen Ausführungsformen ist die Steuerung ungeregelt. Es findet folglich keine Regelung im Rahmen der Ansteuerung statt, sondern nur eine reine Steuerung (im Sinne von "open loop") ohne Regelkreis. Dementsprechend kann die erste Schaltung gegenüber einer geregelten Ansteuerung vereinfacht werden, da insbesondere kein Regler und keine Rückkopplung (Regelschleife) erforderlich sind und die dafür benötigten Schaltungskomponenten somit entfallen können. Damit lassen sich insbesondere auch besonders platzsparende Lösungsvarianten implementieren. Dies ist insbesondere deshalb möglich, weil bei einem periodischen Betrieb, d.h. einem periodischen alternierenden Wechsel zwischen den beiden Schaltungskonfigurationen der Schalteinrichtung, die Spannung über der MEMS-Kapazität im Wesentlichen, d.h. in guter Näherung, als eine lineare Funktion der Periodendauer oder genauer der Dauer der ersten Schaltungskonfiguration modelliert werden kann. So kann auch eine reine Steuerung ohne Regelung für eine ausreichend genaue Einstellung der Spannung über der MEMS-Kapazität und somit einer Ansteuerung des Aktuators mit guter Genauigkeit genügen. Zudem entfallen auch mit einer Regelung einhergehende Energieverluste, so dass die Leistungsaufnahme der erste Schaltung weiter gesenkt und somit ihr Wirkungsgrad bzw. ihre Effizienz weiter gesteigert werden kann.

Bei einigen Ausführungsformen ist die Schalteinrichtung des Weiteren eingerichtet, einen dritten Strompfad wiederholt temporär derart durchgängig zu schalten, insbesondere in Abhängigkeit von der Steuerung, dass über diesen dritten Strompfad die MEMS-Kapazität wiederholt, zumindest teilweise, entladen werden kann, um an der MEMS-Kapazität eine ihrer Höhe nach zeitlich variable Versorgungsspannung des elektro-mechanischen Wandlers zu erzeugen. Das Durchgängigschalten und das dadurch bedingte Entladen können insbesondere periodisch erfolgen. Durch das Entladen lässt sich ein Ladungszustand der MEMS-Kapazität herstellen, der zu einer betragsmäßig niedrigeren Spannung über der MEMS-Kapazität und somit zu einer entsprechend niedrigeren Eingangsspannung am Aktuator führt als im geladenen Ladungszustand (der während der zweiten Konfiguration der Schalteinrichtung erreicht wird). So lässt sich der Aktuator zumindest zwischen zwei Zuständen (geladen/entladen) schalten, die über die elektromechanische Wandlung zu zwei verschiedenen mechanischen Zuständen des Aktuators korrespondieren. Bei einem alternierenden, insbesondere periodischen, Wechsel zwischen den beiden Ladungszuständen lässt sich somit eine korrespondierende, insbesondere periodische, mechanische Bewegung am Aktuator bewirken, die zum Antrieb einer Bewegung, insbesondere Schwingungsbewegung, in einem MEMS (wie etwa einer Spiegelbewegung, insbesondere Spiegeloszillation eines Mikroscannersystems) genutzt werden kann.

Bei einigen Ausführungsformen ist dabei der dritte Strompfad zu einer Pufferkapazität zur Pufferung der Versorgungsspannung geführt, um Ladung von der MEMS-Kapazität bei deren Entladen in die Pufferkapazität zu überführen. So kann die beim Laden der MEMS-Kapazität in diese eingebrachte Ladung zumindest teilweise rückgewonnen und für einen nachfolgenden weiteren Ladevorgang genutzt werden. Auf diese Weise lässt sich die Leistungsaufnahme der erste Schaltung weiter reduzieren und somit deren Wirkungsgrad und damit Effizienz weiter steigern. In dieser Variante wird der dritte Strompfad, zur Unterscheidung von einem alternativen Strompfad gemäß einer anderen Variante zur Entladung ohne Ladungsrückführung bzw. Pufferung, auch als vierter Strompfad bezeichnet.

Bei einigen Ausführungsformen weist die Schaltungseinrichtung auf: (i) einen ersten Schalter, S₁, zum Schalten einer elektrischen Verbindung zwischen der Versorgungsspannung und dem zweiten Pol der Booster-Induktivität; (ii) einen mit dem ersten Pol der Booster-Induktivität elektrisch verbundenen zweiten Schalter, S₂, zum Durchgängigschalten bzw. Unterbrechen des ersten Strompfads; (iii) einen mit dem ersten Pol der Booster-Induktivität elektrisch verbundenen dritten Schalter, S₃, zum Durchgängigschalten bzw. Unterbrechen des zweiten Strompfads; und (iv) einen mit dem zweiten Pol der Booster-Induktivität und der MEMS-Kapazität elektrisch verbundenen vierten Schalter, S₄, zum Durchgängigschalten bzw. Unterbrechen des vierten Strompfads. So lässt sich auf sehr effiziente, insbesondere komponenten- und somit platz- und energiesparende Weise unter Verwendung von nur vier Schaltern in der Schalteinrichtung eine im o.g. Sinne bipolare Implementierung der ersten Schaltung erreichen.

Unter dem Begriff "elektrisch verbunden" ist hier eine unmittelbare elektrische Verbindung ohne dazwischenliegenden Schaltungskomponenten (d.h. Bauelemente) oder aber eine mittelbare Verbindung über eine oder mehrere dazwischenliegenden Schaltungskomponenten (d.h. Bauelemente), z.B. Widerstände, zu verstehen, wobei die Verbindung insbesondere die Charakteristik eines (kleinen) Ohm'schen Widerstands R haben kann, z.B. mit R ≤ 10 Ω.

Bei einigen Ausführungsformen weist die Schaltung des Weiteren einen fünften Schalter, S₅, zum Durchgängigschalten bzw. Unterbrechen eines zwischen dem zweiten Pol der Induktivität und Masse liegenden Strompfads auf.

Insbesondere kann dabei gemäß einiger der Ausführungsformen die Steuerung konfiguriert sein, die Schaltungseinrichtung schrittweise gemäß der nachfolgenden Sequenz in verschiedene Schaltzustände zu versetzen, wobei die Sequenz wenigstens einmal, vorzugsweise mehrfach, insbesondere periodisch, durchlaufen wird:
(a) S₁ und S₂ geschlossen, S₃ und S₄ offen;
(b) S₁ und S₃ geschlossen, S₂ und S₄ offen;
(c) S₂ und S₃ geschlossen, S₁ und S₄ offen;
(d) S₁ und S₂ geschlossen, S₃ und S₄ offen;
(e) S₂ und S₄ geschlossen, S₁ und S₃ offen;
(f) S₂ und S₃ geschlossen, S₁ und S₄ offen.

Bei einigen dieser Ausführungsformen weist die erste Schaltung eine Pufferkapazität, insbesondere einen Kondensator, zur kapazitiven Pufferung der Versorgungsspannung auf. Die Sequenz weist zudem zusätzlich einen weiteren Schaltzustand (b1) auf, der zwischen den Schaltzuständen (b) und (c) liegt und dadurch gekennzeichnet ist, dass in ihm S₁ und S₄ geschlossen und S₂ und S₃ offen sind. So kann beim Entladen der MEMS-Kapazität Ladung aus der MEMS-Kapazität in die Pufferkapazität überführt werden, um für eine weiteren Schaltzyklus zur Verfügung zu stehen, ohne dass die entsprechende Ladungsmenge von der Versorgungsspannungsquelle zur Verfügung gestellt werden muss. So wird auch auf diese Weise die Leistungsaufnahme reduziert und der Wirkungsgrad bzw. die Effizienz der (bipolaren) ersten Schaltung weiter gesteigert.

Bei einigen Ausführungsformen weist die Sequenz zusätzlich (zu den Zuständen (a) bis (f) und optional auch zu (b1)) einen weiteren Schaltzustand (b2) auf, der zwischen den Schaltzuständen (b) und (c) liegt, und dadurch gekennzeichnet ist, dass in ihm S₂ und S₄ geschlossen und S₁ und S₃ offen sind. So kann beim Entladen der MEMS-Kapazität Ladung aus der MEMS-Kapazität durch die Booster-Induktivität geleitet werden, um sie für einen weiteren Schaltzyklus bereits zumindest anteilig mit Energie (in ihrem Magnetfeld) zu laden, ohne dass die aus diesem Strom resultierende Energieaufladung der Booster-Induktivität nachfolgend stattdessen von der Versorgungsspannungsquelle zur Verfügung gestellt werden muss. So kann auch auf diese Weise die Leistungsaufnahme reduziert und somit der Wirkungsgrad bzw. die Effizienz der (bipolaren) ersten Schaltung weiter gesteigert werden.

Bei einigen Ausführungsformen weist die Sequenz zusätzlich einen weiteren Schaltzustand (e1) auf, der dem Schaltzustand (e) folgt und dem Schaltzustand (f) vorausgeht und der dadurch gekennzeichnet ist, dass in ihm S₄ und S₅ geschlossen und S₁, S₂ und S₃ offen sind. Dies ermöglicht eine Rückgewinnung von Energie auch aus negativen Spannungen über der MEMS-Kapazität C_{M} (anschließend an Schaltzustand (e1)).

Bei einigen Ausführungsformen weist die Steuerung (genauer die entsprechende Steuerungseinrichtung) eine mehrstufige Verzögerungskette und einen Multiplexer zum zeitlich gestaffelten Abgreifen der jeweiligen Ausgangssignale der Stufen der Verzögerungskette auf, um ein zeitlich variables Steuerungssignal zur Ansteuerung der Schalteinrichtung zu erzeugen. Die Verzögerungsglieder der Verzögerungskette können hierbei insbesondere aus Standardzellen oder auch als speziell definierte ("customized") analoge Komponenten oder Schaltungsteile ausgeführt sein, wobei die benötigte Verzögerung der einzelnen Stufen sich aus dem Quotienten der maximalnotwendigen Einschaltzeit (Dauer der ersten Schaltungskonfiguration) und der Anzahl der Stufen errechnen lässt. Die analoge Ausführung hätte den Vorteil, dass über eine Einstellung eines Treiberstroms für die Verzögerungsglieder (Stromsteuerung, vgl. "current-starved" Inverter) die Verzögerungszeit jedes einzelnen Verzögerungsgliedes eingestellt werden kann, und somit für beliebige MEMS-Kondensatoren (mit unterschiedlichen Kapazitätswerten und Ausgangsspannungen) optimal einstellbar wäre.

Insbesondere kann gemäß einiger dieser Ausführungsformen die Schalteinrichtung mittels des Steuerungssignals derart ansteuerbar sein, dass mittels des Steuerungssignals ein Umschalten zwischen der ersten Schaltkonfiguration und der zweiten Schaltkonfiguration, oder umgekehrt, bewirkt werden kann.

So lässt sich auf einfache und energieeffiziente Weise eine Steuerung für die Schaltung, insbesondere von deren Schalteinrichtung, realisieren.

### Schaltung mit einem pausierbaren Schwingkreis ("zweite Schaltung")

Ein zweiter Aspekt der Lösung betrifft eine zweite Schaltung zur Ansteuerung eines Aktuators, insbesondere MEMS-Aktuators, zum Antrieb einer Schwingungsbewegung eines Massenelements in einem MEMS. Die Ansteuerung kann insbesondere geregelt oder ungeregelt sein.

Diese zweite Schaltung weist auf:
(i) einen elektrischen Schwingkreis, der eine erste Induktivität (nachfolgend zur Unterscheidung von anderen im weiteren genannten Induktivitäten als "Schwingkreis-Induktivität" bezeichnet, insbesondere eine oder mehrere Spulen aufweisend), eine erste elektrische MEMS-Kapazität, und eine, insbesondere mittels eines Steuersignals, ansteuerbare erste Schalteinrichtung (nachfolgend auch als "Schwingkreis-Schalter" bezeichnet) zum selektiven Unterbrechen bzw. Schließen des Schwingkreises in Abhängigkeit von einer Ansteuerung der ersten Schalteinrichtung enthält und eine auf einen dauerhaft geschlossenen Zustand des Schwingkreises bezogene Resonanzfrequenz aufweist; und
(ii) eine Steuerung zur Ansteuerung der ersten Schalteinrichtung.

Die Steuerung ist konfiguriert, die erste Schalteinrichtung während einer jeweiligen Schwingungsperiode des Schwingkreises durch eine entsprechende Ansteuerung temporär, insbesondere für ein bestimmten Anteil der Schwingungsperiode, in einen Zustand zu versetzen, in dem sie den Schwingkreis unterbricht, um eine tatsächliche Schwingungsfrequenz des Schwingkreises zu bewirken, die kleiner ist als die Resonanzfrequenz.

Mit der zweiten Schaltung lässt sich die effektive Schwingungsfrequenz des Schwingkreises mittels der ersten Schalteinrichtung variabel einstellen. Das temporäre Unterbrechen des Schwingkreises bewirkt ein dazu korrespondierendes Pausieren der elektrischen Schwingung im Schwingkreis ("pausierter Schwingkreis"), was zu einer effektiven Schwingungsfrequenz unterhalb der Resonanzfrequenz des Schwingkreises (in einem dauerhaft geschlossenen Zustand) führt.

Somit lässt sich die geringere effektive Schwingungsfrequenz erreichen, ohne gemäß der Beziehung (1) (vgl. Abschnitt "Begrifflichkeiten" oben) die Werte der (ersten) MEMS-Kapazität C oder der (ersten) Induktivität L vergrößern zu müssen. Wenn schwingungsfähige Komponenten eines MEMS bezüglich ihrer Schwingungsfrequenz eine bestimmte obere Grenzfrequenz nicht überschreiten können oder sollen, dann lassen sich mithilfe des o.g. Konzepts des pausierbaren Schwingkreises effektive Schwingungsfrequenzen erreichen, insbesondere auch variabel einstellen, die bei oder unterhalb der Grenzfrequenz liegen, obwohl dazu Werte für C und L verwendet werden, aus denen sich per Beziehung (1) eine oberhalb der Grenzfrequenz liegende Resonanzfrequenz *f*₀ ergibt. Insbesondere lassen sich somit kleinere und somit platzsparende Induktivitäten L und/oder MEMS-Kapazitäten (insbesondere kapazitive Lasten) C nutzen und so der Platzbedarf für die Schaltung zur Ansteuerung des Aktuators verringern bzw. klein halten.

Des Weiteren wird zum Umladen der MEMS-Kapazität und somit zum Betrieb des dadurch gespeisten Aktuators die periodisch temporär in der ersten Induktivität gespeicherte Energie verwendet bzw. mitverwendet, so dass sich eine besonders verbrauchsarme (periodische) Ansteuerung des Aktuators realisieren lässt. Aufgrund ihres geringen Platzbedarfs als auch ihrer hohen Energieeffizienz ist die Schaltung insbesondere für den Einsatz in mobilen Anwendungen, vor allem auch in tragbaren Geräten mit geringen Abmessungen (z.B. in sog. "Wearables'"), geeignet.

Die Möglichkeit, die effektive Schwingungsfrequenz bei gegebenen Werten für C und L anhand der Steuerung mittels der ersten Schalteinrichtung variabel einstellen zu können, kann zudem vorteilhaft dazu genutzt werden, Bauteiltoleranzen, insbesondere im Rahmen einer Massenfertigung, zu kompensieren.

Nachfolgend werden verschiedene beispielhafte Ausführungsformen der zweiten Schaltung beschrieben, die jeweils, soweit dies nicht ausdrücklich ausgeschlossen wird oder technisch unmöglich ist, beliebig miteinander sowie mit den hierin beschriebenen anderen Aspekten der Lösung kombiniert werden können.

Bei einigen Ausführungsformen ist die MEMS-Kapazität derart als Bestandteil des Aktuators ausgebildet, dass sie einen Bestandteil eines elektro-mechanischen Wandlers des Aktuators bildet. Der Wandler ist dabei konfiguriert, in der MEMS-Kapazität gespeicherte elektrische Energie in zumindest eine mechanische Größe zum Antrieb einer Bewegung des Aktuators zu wandeln. Der Aktuator kann insbesondere ein MEMS-Aktuator sein, z.B. ein Piezoaktor. Die über der MEMS-Kapazität im Rahmen der elektrischen Schwingung im Schwingkreis abfallende Spannung kann somit direkt und ohne weitere kapazitive Pufferung dem Aktuator zur Verfügung gestellt werden, so dass ein hoher Wirkungsgrad der zweiten Schaltung erreicht werden kann.

Bei einigen Ausführungsformen ist die Steuerung konfiguriert, in einer jeweiligen Schwingungsperiode des Schwingkreises die erste Schalteinrichtung in einen Zustand zu versetzen, in dem sie den Schwingkreis unterbricht, wenn die Spannung über der MEMS-Kapazität betragsmäßig ein Maximum innerhalb der Schwingungsperiode erreicht. Die im Schwingkreis befindliche Energie wird somit, zumindest größtenteils, während der durch die Unterbrechung bedingten Pausierung der Schwingung in der MEMS-Kapazität in Form von elektrischer Energie gespeichert gehalten, bis durch Schließen des Schwingkreises die Schwingung fortgesetzt wird. Diese Speicherung während der Pausierung des Schwingkreises kann, jedenfalls bei einer verlustarmen MEMS-Kapazität, über eine langen Zeitraum weitgehend aufrechterhalten werden, so dass sich ohne signifikante (insbesondere anwendungsbezogen inakzeptable) Energieverluste eine entsprechend großer Wertebereich für die variable einstellbare effektive Schwingungsfrequenz des Schwingkreises erreichen lässt.

Speziell kann die Steuerungsschaltung insbesondere dazu konfiguriert sein, in einer jeweiligen Schwingungsperiode des Schwingkreises die erste Schalteinrichtung in einen Zustand zu versetzen, in dem sie den Schwingkreis unterbricht, wenn die Spannung über der MEMS-Kapazität innerhalb der Schwingungsperiode nach einer während der Schwingungsperiode erfolgenden Umladung der MEMS-Kapazität betragsmäßig ein Maximum erreicht. So kann erreicht werden, dass die maximal zur Verfügung stehende Energie zum Umladen des Kondensators verwendet wurde und der Resonanzschwingkreis die gesamte Leistungsaufnahme optimal reduziert. Auch kann so erreicht werden, dass der Strom in der Induktivität ein Minimum erreicht hat bzw. gegen null geht und somit keine Spannungsspitzen durch die Induktivität auftreten.

Bei einigen Ausführungsformen weist der Schwingkreis zusätzlich zur MEMS-Kapazität eine davon separat ausgebildete zweite MEMS-Kapazität mit (bezüglich der ersten MEMS-Kapazität) gleichem oder verschiedenen Kapazitätswert auf. Die MEMS-Kapazität und die zweite MEMS-Kapazität sind in dem Schwingkreis so verschaltet, dass ein erster Pol der MEMS-Kapazität mit einem ersten Pol der zweiten MEMS-Kapazität über zumindest einen Schalter der ersten Schalteinrichtung und die Schwingkreis-Induktivität elektrisch verbunden ist und die jeweiligen zweiten Pole der beiden MEMS-Kapazitäten so miteinander elektrisch verbunden sind, dass sie bei Betrieb des Schwingkreises auf einem selben (konstanten oder zeitlich variablen) elektrischen Potenzial gehalten werden.

Auf diese Weise können an den beiden MEMS-Kapazitäten zueinander bezüglich ihres Vorzeichens komplementäre Spannungen abgegriffen werden. Um auf eine gewünschte Differenzspannung zwischen den potenzialmäßig am weitesten auseinanderliegenden Polen dieser Kombination aus MEMS-Kapazitäten zu kommen, genügt es daher die beiden einzelnen MEMS-Kapazitäten auf eine betragsmäßig geringere Spannung zu laden, da sich die beiden Spannungen addieren. Das o.g. genannte Prinzip des pausierbaren Schwingkreises bleibt dabei, zumindest im Wesentlichen, unberührt. Eine solche Konfiguration kann insbesondere vorteilhaft genutzt werden, um einen differentiellen Antrieb eines schwingungsfähigen MEMS, insbesondere einen Antrieb einer Schwingungsbewegung eines Ablenkelements eines Mikroscanners, zu bewerkstelligen.

Ein solcher Antrieb ist dabei vor allem im Hinblick auf das Erreichen einer möglichst gleichförmigen, ruckfreien Schwingung des Ablenkelements (Spiegels) des Mikroscanners und/oder zur Verringerung der Leistungsaufnahme vorteilhaft. Die zweite MEMS-Kapazität kann dann ebenfalls als MEMS-Kapazität eines (insbesondere zweiten) Aktuators ausgebildet sein und dabei Teil eines Wandlers bilden, der konfiguriert ist, in der zweiten MEMS-Kapazität gespeicherte elektrische Energie in zumindest eine mechanische Größe zum Antrieb einer Bewegung dieses Aktuators zu wandeln.

Bei einigen Ausführungsformen weist die zweite Schaltung des Weiteren eine Energieversorgungsschaltung zur temporären Zufuhr von elektrischer Energie in den Schwingkreis auf. So lässt sich trotz der in der Realität unvermeidlichen Verluste (z.B. durch Wärmeentwicklung in parasitären, insbesondere ohmeschen, Widerständen der realen Schaltung), Abstrahlungen von elektromagnetischen Wellen bei höheren Frequenzen oder Reibungen im MEMS oder Luftreibungen von bewegten Teilen des MEMS) ein längerer, insbesondere sogar dauerhafter Betrieb des MEMS realisieren, in dem die Energieversorgungsschaltung die Energieverluste zumindest teilweise ausgleichen kann. So lässt sich die Energie im Schwingkreis aufrechterhalten oder jedenfalls deren Abbau verlangsamen.

Bei einigen Ausführungsformen weist die Energieversorgungsschaltung eine zweite Schalteinrichtung auf, die konfiguriert ist, in Abhängigkeit von einer Ansteuerung, insbesondere durch die Steuerung, einen ersten Einspeisungspunkt für elektrische Energie temporär mit dem Schwingkreis zu verbinden, um den Schwingkreis mit am ersten Einspeisungspunkt zugeführter bzw. zuführbarer elektrischer Energie zu versorgen. Damit lässt sich die Energiezufuhr in den Schwingkreis, insbesondere um diesen anfänglich aufzuschwingen bzw. im nachfolgenden Betrieb dessen Energieverluste zu kompensieren, anhand der Ansteuerung genau einstellen, insbesondere deren zeitlicher Verlauf optimieren.

Speziell kann dazu die zweite Schaltung gemäß einigen Ausführungsformen konfiguriert sein, insbesondere durch eine entsprechende Ansteuerung, in einer jeweiligen Schwingungsperiode des Schwingkreises die zweite Schalteinrichtung dann temporär zu schließen, wenn die Spannung über der MEMS-Kapazität betragsmäßig ein Maximum innerhalb der Schwingungsperiode erreicht und die gleiche Polung wie eine von der Energieversorgungsschaltung am ersten Einspeisungspunkt zur Verfügung gestellte Spannung aufweist. Die MEMS-Kapazität wird dementsprechend nachgeladen, wenn sie gerade im Rahmen der bereits erfolgenden elektrischen Schwingung im Schwingkreis gerade maximal aufgeladen ist, so dass nur noch eine Zusatzladung zum Auffüllen der Ladung der MEMS-Kapazität auf eine Sollspannung von der Energieversorgungsschaltung geliefert werden muss. Im vorgenannten Falle, dass im Schwingkreis auch eine zweite MEMS-Kapazität vorgesehen ist, kann dies dort unter Berücksichtigung der entgegengesetzten Polung entsprechend implementiert sein.

Bei einigen Ausführungsformen ist die zweite Schaltung konfiguriert, in der jeweiligen Schwingungsperiode mittels der zweiten Schalteinrichtung den ersten Einspeisungspunkt temporär mit dem Schwingkreis zu einem Zeitpunkt zu verbinden, vor dem in der Schwingungsperiode bereits zwei aufeinanderfolgende Umladevorgänge der MEMS-Kapazität des Schwingkreises erfolgt sind, seit zuletzt mittels der zweiten Schalteinrichtung der erste Einspeisungspunkt temporär mit dem Schwingkreis verbunden wurde. Dies kann insbesondere im Hinblick auf eine effiziente und kompakte Realisierung vorteilhaft sein, denn es reicht dann aus, lediglich eine einzige Hochspannungsquelle, wahlweise mit positiver oder negativer Polung der Ausgangsspannung, vorzusehen. Insbesondere dann, wenn eine solche Hochspannungsquelle herkömmliche spulenbasierte Hochsetzsteller zur Spannungserhöhung aufweist, kann auf einer Platine entsprechend eine Spule eingespart werden. Gerade bei der Umsetzung der Schaltung unter Verwendung einer integrierten Schaltung (IC, z.B. ASIC), bei der kaum zusätzliche IC-externe Bauelemente notwendig sind, kann dies ein Vorteil sein.

Bei einigen Ausführungsformen ist die zweite Schaltung konfiguriert, in der jeweiligen Schwingungsperiode mittels der zweiten Schalteinrichtung den ersten Einspeisungspunkt temporär mit dem Schwingkreis elektrisch zu verbinden und dabei die MEMS-Kapazität zu laden, während die erste Schalteinrichtung sich in einem Zustand befindet, in dem sie die Schwingkreis-Induktivität von dem ersten Einspeisungspunkt elektrisch trennt. Der vom ersten Einspeisungspunkt kommende Ladestrom wird somit in den Schwingkreis, genauer in die MEMS-Kapazität, eingespeist, während der Schwingkreis unterbrochen ist. Der Ladestrom wird somit im Wesentlichen vollständig, d.h. insbesondere von etwaigen parasitären Verlusten abgesehen, zum Nachladen der MEMS-Kapazität genutzt, während zu diesem Zeitpunkt die Schwingkreis-Induktivität stromlos bleibt. So lässt sich insbesondere eine sehr schnelle und effektive Energieversorgung des Schwingkreises zur Kompensation von aufgetretenen Energieverlusten realisieren.

Bei einigen Ausführungsformen ist die zweite Schaltung dahingehend konfigurierbar, dass die Menge der dem Schwingkreis in zumindest einer Schwingungsperiode zugeführten elektrische Energie einstellbar ist. Dies kann auf verschiedene Weise erreicht werden. Beispielsweise kann die Dauer der Nachladung zeitlich variiert werden, die Stromstärke des Nachladestroms (insbesondere über Einstellen der ihn treibenden Spannung) eingestellt werden oder die Frequenz, mit der nachgeladen wird angepasst werden, beispielsweise so, dass die Nachladung nur jede m-te Periode der elektrischen Schwingung im Schwingkreis erfolgt, wobei m > 0 eine natürliche Zahl ist.

Die zweite Schaltung kann hierbei insbesondere dahingehend konfigurierbar sein, dass die Menge der dem Schwingkreis zugeführten elektrische Energie für jede Schwingungsperiode individuell (z.B. mittels einer Regelung) oder global für alle m-ten Schwingungsperioden gleich einstellbar ist, wobei m > 0 wieder eine natürliche Zahl ist.

Bei einigen Ausführungsformen weist die Energieversorgungsschaltung eine induktive Kopplungseinrichtung, insbesondere ein induktiv gekoppeltes Spulenpaar, zur temporären induktiven Einspeisung von elektrischer Energie in den Schwingkreis auf. Dies kann zusätzlich oder alternativ zu einer leitungsgebundenen Stromeinspeisung in den Schwingkreis vorgesehen sein. So kann die Energieversorgungsschaltung, jedenfalls bei Wegfall einer leitungsgebundenen Stromeinspeisung, galvanisch vom Schwingkreis entkoppelt werden.

Bei einigen Ausführungsformen weist die Energieversorgungsschaltung eine dritte Schalteinrichtung auf, die konfiguriert ist, in Abhängigkeit von einer Ansteuerung einen zweiten Einspeisungspunkt für elektrische Energie temporär mit dem Schwingkreis zu verbinden, um den Schwingkreis derart mit am zweiten Einspeisungspunkt zugeführter bzw. zuführbarer mit elektrischer Energie zu versorgen, dass die Polung einer dabei am ersten Einspeisungspunkt anliegenden ersten elektrischen Versorgungsspannung der Polung einer zugleich am zweiten Einspeisungspunkt anliegenden zweiten elektrischen Versorgungsspannung entgegengesetzt ist und so eine bipolare Energieversorgung des Schwingkreises ermöglicht ist.

Die Erzeugung und/oder Einspeisung der zweiten Versorgungsspannung kann insbesondere gemäß einer oder mehrerer hierin im Hinblick auf die dem ersten Einspeisungspunkt zugeführten Versorgungsspannung entsprechen, insbesondere (bis auf die unterschiedliche Polung) identisch damit sein.

### Kombinierte Schaltung mit Hochsetzsteller und pausierbarem Schwingkreis

Die vorgenannten Prinzipien der ersten Schaltung und der zweiten Schaltung können im Rahmen der Lösung auch in Kombination genutzt werden.

Eine derart kombinierte Schaltung ergibt sich gemäß einer ersten Betrachtungsweise insbesondere, indem ausgehend von der ersten Schaltung (insbesondere ausgehend von einer ihrer hierin beschriebenen Ausführungsformen), des Weiteren ein Schwingkreis vorgesehen ist bzw. wird, der eine Kapazität, die zumindest anteilig durch die MEMS-Kapazität definiert ist, eine Schwingkreis-Induktivität und eine ansteuerbaren zweite Schalteinrichtung zum selektiven Unterbrechen bzw. Schließen des Schwingkreises in Abhängigkeit von einer Ansteuerung der zweiten Schalteinrichtung aufweist. Dabei weist der Schwingkreis eine auf einen dauerhaft geschlossenen Zustand des Schwingkreises bezogene Resonanzfrequenz auf. Zudem ist die Steuerung des Weiteren zur Ansteuerung der zweiten Schalteinrichtung derart konfiguriert ist, dass sie die zweite Schalteinrichtung während einer jeweiligen Schwingungsperiode des Schwingkreises temporär für ein bestimmten Anteil der Schwingungsperiode öffnet, um dadurch eine Unterbrechung des Schwingkreises und somit eine tatsächliche Schwingungsfrequenz des Schwingkreises zu bewirken, die kleiner ist als die Resonanzfrequenz.

Die Schaltung kann insbesondere jede, insbesondere eine oder mehrere der hierin beschriebenen Ausführungsformen der zweiten Schaltung aufweisen.

Die im Schwingkreis erzeugten elektrischen Schwingungen führen somit zu einer zeitlich veränderlichen, insbesondere alternierenden, Ladung und somit Spannung der MEMS-Kapazität, so dass auch die mechanische Größe zum Antrieb einer Bewegung des Aktuators, zu dem die MEMS-Kapazität gehört, entsprechend variiert.

Eine derart kombinierte Schaltung ergibt sich zudem gemäß einer zweiten Betrachtungsweise insbesondere, indem ausgehend von der zweiten Schaltung mit Energieversorgungsschaltung, diese Energieversorgungsschaltung einen Aufwärtswandler aufweist, der konfiguriert ist, eine am Einspeisungspunkt angelegte Eingangsspannung in eine demgegenüber betragsmäßig höhere Ausgangsspannung zu wandeln, um den Schwingkreis anhand dieser Ausgangsspannung mit elektrischer Energie zu versorgen, wenn die zweite Schalteinrichtung sich in einem Zustand befindet, in dem sie den Einspeisungspunkt temporär mit dem Schwingkreis elektrisch verbindet. Auf diese Weise kann auf eine Hochvoltquelle verzichtet werden und stattdessen nur eine Niedervoltspannungsquelle zur Bereitstellung einer Versorgungsspannung für die zweite Schaltung eingesetzt werden. Der Aufwärtswandler kann insbesondere eine Hochsetzstellerschaltung gemäß der ersten Schaltung aufweisen, wobei die Schwingkreis-Kapazität zumindest anteilig durch die MEMS-Kapazität der Hochsetzstellerschaltung gebildet wird.

Die Schaltung kann, insbesondere im Falle von mehr als einem Einspeisungspunkt je Einspeisungspunkt individuell oder gleich, jede, insbesondere eine oder mehrere, der hierin beschriebenen Ausführungsformen der Hochsetzstellerschaltung aus der ersten Schaltung als Hochsetzstellerschaltung aufweisen.

### MEMS, insbesondere Mikroscannersystem

Ein dritter Aspekt der vorliegenden Lösung betrifft ein MEMS, aufweisend: (i) ein schwingungsfähig konfiguriertes Massenelement; (ii) einen Aktuator zum Antrieb einer Schwingungsbewegung des Massenelements; und (iii) eine Schaltung nach dem ersten Aspekt oder dem zweiten Aspekt oder eine daraus kombinierte Schaltung, jeweils zur Ansteuerung des Aktuators derart, dass dieser dadurch veranlasst wird, das schwingungsfähige Massenelement in einer Schwingungsbewegung zu bewegen.

Dabei ist die MEMS-Kapazität derart als Bestandteil des Aktuators ausgebildet, dass sie selbst einen Bestandteil eines elektro-mechanischen Wandlers des Aktuators bildet, und der Wandler konfiguriert ist, in der MEMS-Kapazität gespeicherte elektrische Energie in zumindest eine mechanische Größe zum Antrieb einer Bewegung des Aktuators zu wandeln, um damit die Schwingungsbewegung des Massenelements anzutreiben.

Bei einigen Ausführungsformen weist das MEMS ein Mikroscannersystem auf und das Massenelement ist als schwingungsfähig konfiguriertes Ablenkelement des Mikroscannersystems zum Ablenken von auf das Ablenkelement einfallender elektromagnetischer Strahlung ausgebildet. So lässt sich ein besonders energieeffizienter Antrieb der Bewegung, insbesondere des Ablenkelements, insbesondere zum Scannen eines elektromagnetischen Strahls (z.B. Laserstrahl) erreichen.

Die in Bezug auf den ersten bzw. zweiten Aspekt der Lösung erläuterten Merkmale und Vorteile gelten entsprechend auch für das Mikroscannersystem gemäß dem dritten Aspekt der Lösung.

Weitere Vorteile, Merkmale und Anwendungsmöglichkeiten der vorliegenden Lösung ergeben sich aus der nachfolgenden detaillierten Beschreibung im Zusammenhang mit den Figuren.

Dabei zeigt:
**Fig. 1** als Ausgangspunkt für die Erläuterung der ersten Schaltung aus Fig. 2A: eine herkömmliche Schaltung zum Ansteuern eines kapazitiven Aktuators mit einem geregelten Hochsetzsteller;
**Fig. 2A** eine erste beispielhafte Ausführungsform der ersten Schaltung, die ein unipolares Ansteuern des Aktuators ermöglicht;
**Fig. 2B** einen Vergleich der Schaltungen aus den Figuren 1 und 2A;
**Fig. 3** ein Diagramm zur Darstellung eines zeitlichen Stromverlaufs durch die Induktivität der Schaltung aus Fig. 2A/2B bei deren Betrieb, während in der Induktivität die magnetische Energie aufgebaut wird;
**Fig. 4** eine beispielhafte Ausführung einer Steuerungseinrichtung zur Steuerung einer ersten Schaltung, insbesondere gemäß Fig. 2A.
**Fig. 5** eine zweite beispielhafte Ausführungsform der ersten Schaltung, die ein bipolares Ansteuern des Aktuators ermöglicht;
**Fig. 6** einen beispielhaften zeitlichen Verlauf der Konfiguration der Schalteinrichtung der Schaltung aus Fig. 5, insbesondere der Schaltzustände ihrer einzelnen Schalter; und
**Fig. 7** als Ausgangspunkt für die Erläuterung der zweiten Schaltung aus Fig. 8: eine herkömmliche Schaltung zur Ansteuerung eines MEMS-Aktuators zum Antrieb eines schwingungsfähigen MEMS, bei der ein Umladen einer MEMS-Kapazität des MEMS-Aktuators anhand einer Halbbrücke unter Verwendung zweier gegenpoliger Versorgungsspannungen erfolgt;
**Fig. 8** eine erste beispielhafte Ausführungsform der zweiten Schaltung, mit einem pausierbaren Schwingkreis sowie mit einer Hochspannungsquelle zur Bereitstellung einer Versorgungsspannung für die Schaltung;
**Fig. 9** eine qualitative Darstellung der Verläufe der Spannung an der MEMS-Kapazität des Schwingkreises und des von der Hochspannungsquelle zu liefernden Ladestroms bei der Schaltung aus Fig. 8;
**Fig. 10** eine zweite beispielhafte Ausführungsform der zweiten Schaltung mit einem pausierbaren Schwingkreis sowie mit einer über ein gekoppeltes Spulenpaar induktiv an den Schwingkreis gekoppelten Hochspannungsquelle zur Bereitstellung einer Versorgungsspannung für die Schaltung;
**Fig. 11** eine dritte beispielhafte Ausführungsform der zweiten Schaltung mit einem pausierbaren Schwingkreis sowie mit einer auf zwei separate MEMS-Kapazitäten aufgeteilten Schwingkreiskapazität;
**Fig. 12** eine erste beispielhafte Ausführungsform einer Schaltung, in der die Konzepte der ersten Schaltung und der zweiten Schaltung kombiniert sind, um eine Schaltung mit unipolarem Hochsetzsteller und pausierbarem Schwingkreis zu bilden;
**Fig. 13** eine zweite beispielhafte (bipolare) Ausführungsform einer Schaltung in der die Konzepte der ersten Schaltung und der zweiten Schaltung kombiniert sind, um eine Schaltung mit bipolarem Hochsetzsteller und pausierbarem Schwingkreis zu bilden; und
Fig. **14** eine dritte beispielhafte (bipolare) Ausführungsform einer Schaltung in der die Konzepte der ersten Schaltung und der zweiten Schaltung kombiniert sind, um eine Schaltung zum differentiellen und bipolaren Ansteuern eines MEMS-Aktuators zu bilden.
Fig. **15** eine beispielhafte Ausführungsform eines MEMS, hier speziell als Mikroscanner.

In den Figuren bezeichnen gleiche Bezugszeichen regelmäßig gleiche, ähnliche oder einander entsprechende Elemente (außer in einigen Fällen bei der Benennung von Schalteinrichtungen). In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und genereller Zweck dem Fachmann verständlich werden. In den Figuren dargestellte Verbindungen und Kopplungen zwischen funktionellen Einheiten und Elementen können, soweit nicht ausdrücklich anders angegeben, auch als indirekte Verbindung oder Kopplung implementiert werden. Die Steuerung bzw. Steuerungseinrichtung, kann insbesondere mittels Hardware, Software oder mittels einer Kombination aus Hardware und Software implementiert werden.

### Beispielhafte Ausführungsformen der ersten Schaltung

Es folgen nun zunächst Erläuterungen zu beispielhaften Ausführungsformen der ersten Schaltung, wobei zunächst von der herkömmliche Schaltung 100 aus Fig. 1 ausgegangen wird:
Die Schaltung 100 aus Fig. 1 entspricht einem typischen Aufbau eines asynchronen Hochsetzstellers (engl. DC/DC-Converter) aus dem Stand der Technik und wird hier zu Referenzzwecken erläutert, insbesondere um wichtige Unterschiede gegenüber lösungsgemäßen Schaltungen kenntlich zu machen.

Eine Spannungsquelle stellt eine Versorgungsspannung U_{V} als Gleichspannung zur Verfügung und speist damit eine Induktivität (Spule) L, wenn ein Stromkreis durch die Induktivitäten geschlossen wird. Der Widerstand R_{L} stellt im Sinne eines Ersatzschaltbilds den ohmschen Widerstand der Induktivität dar und ist im Rahmen der weiteren Diskussion der Schaltung(en) nicht relevant.

In einer ersten Phase des Betriebs der Schaltung wird der Stromkreis durch die Induktivität L geschlossen, indem der Feldeffekt-Transistor T leitend geschaltet wird. Dies erfolgt über einen Regler Reg, der den Transistor T entsprechend über dessen Gate ansteuert. Durch den Stromfluss durch die Induktivität L baut diese ein Magnetfeld auf, in dem von der Versorgungsspannung U_{V} zur Verfügung gestellte Energie gespeichert ist (in Form von magnetischer Energie).

Wird nun in einer zweiten Phase durch den Regler Reg der Transistor T sperrend geschaltet, so versucht die Induktivität L trotz Unterbrechung des bisherigen Stromkreises, ihren magnetischen Fluss gemäß der Lenz'schen Regel bzw. dem Induktionsgesetz aufrechtzuerhalten, indem eine Spannung induziert wird, sodass er dadurch generierte Strom ein Magnetfeld erzeugt, welches der Änderung des magnetischen Flusses entgegenwirkt. Die induzierte Spannung führt insbesondere dazu, dass die Diode D oberhalb ihrer Schwellspannung in Durchlassrichtung geschaltet wird und der (zumindest anteilig zusätzlich zur Versorgungsspannung U_{V}) aus dem magnetischen Feld der Induktivität L gespeiste generierte Strom in die Pufferkapazität C abfließen kann, sodass sich dort eine Ausgangsspannung U_{A} über der Pufferkapazität C aufbaut. Die Diode wirkt hier somit ähnlich einem Schalter.

Die Erzeugung der Ausgangsspannung U_{A} ist dabei geregelt, wozu eine Regelschleife mit einem Spannungsteiler aus den Widerständen R₁ und R₂ sowie einem Operationsverstärker OP vorgesehen ist, dessen Ausgang zum Schließen der Regelschleife mit einem Eingang des Reglers Reg elektrisch leitend verbunden ist. Zur Ansteuerung des Reglers Reg wird die an der Mittelabzapfung des Spannungsteilers auftretende Spannung anhand des Operationsverstärkers OP mit einer festgelegten Referenzspannung V_{ref} verglichen und in Abhängigkeit vom Ergebnis des Vergleichs eine variable Frequenz oder ein variabler Duty Cycle (alternative deutsche Begriffe sind "Tastgrad" und "Aussteuergrad") eines Ausgangssignals des Reglers Reg bestimmt, mit dem der Transistor T angesteuert wird. So lässt sich mit der Regelung die Ausgangsspannung U_{A} am Pufferkondensator C auf einen im Wesentlichen konstanten Wert auslegen, der insbesondere von der Referenzspannung V_{ref} abhängt.

Die Ausgangsspannung U_{A} kann nun als Treiberspannung verwendet werden, um durch Schließen eines Schalters S₁ eine elektrische Verbindung zu einem MEMS-Aktuator durchgängig zu schalten, um diesen zu treiben. Der MEMS-Aktuator kann - wie dargestellt - insbesondere eine MEMS-Kapazität C_{M} aufweisen und insbesondere ein Piezoaktuator sein, bei dem die MEMS-Kapazität C_{M} zusammen mit einem zwischen ihren beiden verschiedenpoligen Elektroden angeordneten Piezomaterial als Piezoelement wirkt. Mittels eines parallel zur MEMS-Kapazität C_{M} geschalteten Schalters S₂ kann die MEMS-Kapazität C_{M} wieder entladen werden, insbesondere auf 0V. Über eine entsprechende Ansteuerung der Schalter S₁ und S₂ kann somit eine Anregungsfrequenz für den MEMS-Aktuator festgelegt werden mit der die MEMS-Kapazität C_{M} zwischen einem geladenen und einem ungeladenen Zustand hin und her schwingt und entsprechend den MEMS-Aktuator in eine oszillierende mechanische Bewegung versetzt, die wiederum zum Antrieb einer mechanischen Bewegung einer weiteren Komponente genutzt werden kann. Die Schalter S₁ und S₂ können insbesondere auch durch Transistoren realisiert sein.

Die durch die Schaltung 100 erzeugbare Hochspannung kann insbesondere bis zu 200 V bei einer Frequenz von bis zu 100 kHz betragen, sodass die Schalter S₁ und S₂ dann entsprechend als Hochspannungsschalter auszulegen sind. Wird die Pufferkapazität C mit einer Konstantspannungsquelle für die Versorgungsspannung U_{V} geladen, wie dies bei der Schaltung 100 der Fall ist, so beträgt der theoretische Wirkungsgrad aufgrund der Speisung der MEMS-Kapazität C_{M} aus der Pufferkapazität C und dem daraus resultierenden Auftreten des sogenannten "Kondensator-Paradoxons" jedoch maximal nur 50 %. Der verbleibende Teil der aufgebrachten Energie fällt als Verlustleistung an, insbesondere im Widerstand des (Hochspannung-) Schalters S1, dem ohmschen Widerstand RL der Spule und den Zuleitungen als Verlustleistung.

Typische Eigenschaften einer solchen herkömmlichen Schaltung 100 sind daher:
- Geringer Wirkungsgrad aufgrund des Kondensator-Paradoxons
- Permanentes Schalten des Transistors T, zum Nachliefern der im Mittel verbrauchten Ladung zum periodischen Umladen der MEMS Kapazität C_{M} (Führt zu höherer Gesamtleistungsaufnahme durch Schaltverluste und kann außerdem zu Rauschen in anderen Schaltungsteilen führen)
- Verhältnismäßig hohe Leistungsaufnahme aufgrund der permanenten Regelung der Ausgangsspannung
- Großes Systemvolumen (Benötigt eine Regelung der Ausgangsspannung und einen Hochspannungsschalter S₁, was zu hohen Regel- und Schaltverlusten führt)
- Hohe Schaltungskomplexität insgesamt
- Benötigt analoge Baugruppen zur Gewährleistung der Regelstabilität des Hochsetzstellers
- Benötigt einen Hochspannungsschalter S₁, welcher aufwendig aufgebaut werden muss (z.B. Bootstrap-Schaltung o.Ä.) und somit nicht energieeffizient ist.

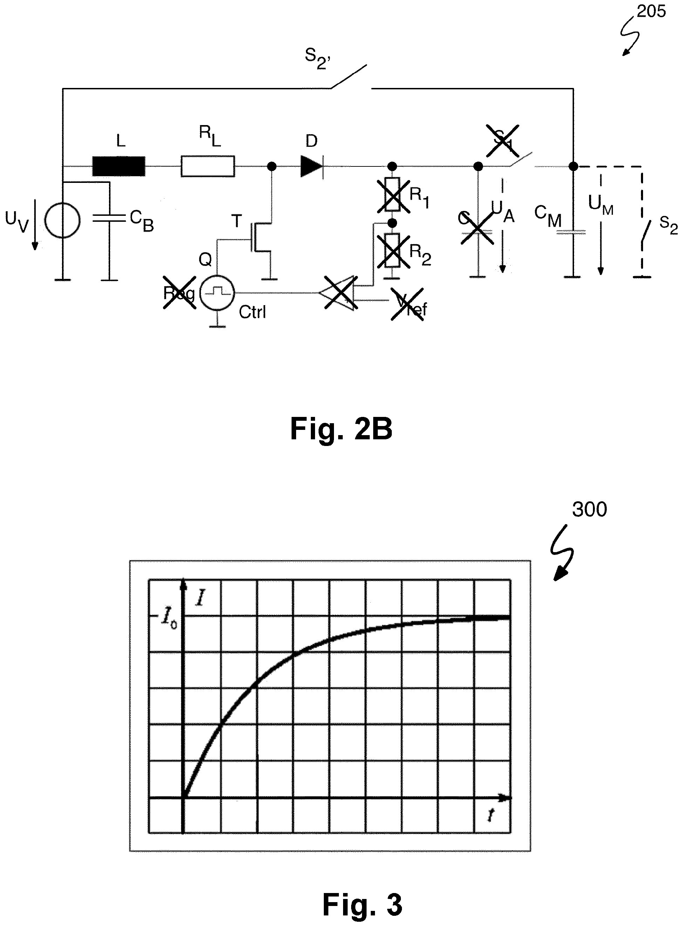

**Fig. 2A** zeigt dagegen eine erste beispielhafte Ausführungsform 200 einer ersten Schaltung, mit der einer oder mehrere der vorgenannten Nachteile reduziert oder sogar vermieden werden können. In **Fig. 2B** ist im Rahmen eines Vergleichs 205 der Schaltungen 100 und 200 illustriert, welche Schaltungskomponenten bei der Schaltung 200 eingespart werden können.

Im Unterschied zur Schaltung 100, wird der Transistor T nicht mehr durch einen Regler (closed-loop) sondern durch eine Steuerung (open-loop) Ctrl mittels eines Steuersignals Q angesteuert und der Ladestrom fließt nicht in eine Pufferkapazität C, von der aus dann zeitlich nachfolgend die MEMS-Kapazität C_{M} geladen wird, sondern er fließt direkt ohne kapazitive Pufferung in die MEMS-Kapazität C_{M} des Aktuators, insbesondere MEMS-Aktuators, um dort eine Antriebsspannung U_{M} über der MEMS-Kapazität C_{M} aufzubauen.

Die MEMS-Kapazität C_{M} ist als Bestandteil des Aktuators ausgebildet, sodass sie einen Bestandteil eines elektro-mechanischen Wandlers des Aktuators bildet, wobei der Wandler konfiguriert ist, in der MEMS-Kapazität C_{M} gespeicherte elektrische Energie in zumindest eine mechanische Größe zum Antrieb einer Bewegung des Aktuators zu wandeln. Der Aktuator kann insbesondere ein Piezo-Aktuator bzw. Piezoelement sein, bei dem ein piezoelektrisches Material zwischen den Elektroden der MEMS-Kapazität C_{M} so angeordnet ist, dass es beim Auftreten einer elektrischen Spannung U_{M} zwischen den Elektroden im zugehörige elektrischen Feld liegt und sich gemäß dem inversen Piezoeffekt verformt, wodurch elektrische Energie in mechanische Energie gewandelt wird.

Die Schaltung 200 weist eine Schalteinrichtung auf, zu welcher der Transistor T, die Diode D und der Schalter S_{2'} gehören. Optional kann der schon aus Fig. 1 bekannte weitere Schalter S₂ vorhanden sein, um die MEMS-Kapazität C_{M} darüber optional direkt gegen Masse entladen zu können, insbesondere nach erfolgter Energierückgewinnung in einen versorgungsseitigen Pufferkondensator C_{B}. Angenommen, die Versorgungsspannung sei x, z.B. 3V, dann könnte unter Verwendung des Schalters S₂ unterm Strich zusätzlich eine um x erhöhte Spannungsänderung über der MEMS-Kapazität C_{M} erzeugt werden. Allerdings sollte hierzu der Schalter S₂ nur kurzzeitig geschlossen werden, um währenddessen ein "Aufladen" der Induktivität L durch einen aus der Versorgungsspannung U_{V} gespeisten Strom zu vermeiden. Alternativ kann dafür stattdessen die Versorgungsspannung U_{V} während der Entladung der MEMS-Kapazität C_{M} durch einen optional vorhandenen weiteren Schalter (nicht dargestellt) von der Induktivität L entkoppelt werden.

Wie sich insbesondere mit Blick auf **Fig. 2B** ergibt, weist die Schaltung 200 gegenüber der Schaltung 100 eine deutlich geringere Komplexität bei signifikant höherem Wirkungsgrad auf, insbesondere aufgrund der Vermeidung des (Hochspannungs-) Schalters S₁, des Pufferkondensators C und des damit verbundenen Kondensator-Paradoxons sowie der Regelung einschließlich der zugehörigen Regelungsschleife mit dem Spannungsteiler R₁, R₂, dem Operationsverstärker OP, dem Regler Reg und dessen Schaltfrequenzerzeugungsfunktion für den Transistor T.

Die Funktionsweise der Schaltung aus Fig. 2A/2B kann wie folgt beschrieben werden:
Ist der Transistor T mittels einer entsprechenden Ansteuerung durch die Steuerung Ctrl durchgeschaltet ("erste" Schaltungskonfiguration), so ist dadurch ein erster Strompfad durch die Induktivität L durchgängig geschaltet, um einen von der Versorgungsspannung U_{V} gespeisten ansteigenden Stromfluss durch die Induktivität L zu bewirken. Dabei steigt der Strom durch die Induktivität L (zunächst näherungsweise linear) an. Der Widerstand R_{L} soll hierbei (im Sinne eines Ersatzschaltbilds) den Wicklungswiderstand der Induktivität L (Spule) repräsentieren.

Nach der Zeit t_{L} wird der Transistor T sperrend geschaltet ("zweite" Schaltungskonfiguration), sodass ein kapazitiv-ungepufferter zweiter Strompfad zwischen einem ersten Pol der Induktivität L und der MEMS-Kapazität C_{M} durchgängig geschaltet ist, über den die MEMS-Kapazität C_{M} direkt mittels eines zumindest anteilig durch die Induktivität L gespeisten Stromflusses durch die dann in Durchlassrichtung gepolte Diode D hindurch auf eine erste Spannung aufgeladen wird, die betragsweise gleich oder höher ist als die Versorgungsspannung U_{V}. Dabei wird die in der Induktivität L gespeicherte magnetische Energie abgebaut und in die sich in der MEMS-Kapazität C_{M} aufbauende elektrische Energie direkt umgewandelt.

Betrachtet man den zeitlichen Verlauf 300 des durch die Induktivität L fließenden Stroms während der ersten Schaltungskonfiguration, so kann dieser, wie in Fig. 3 illustriert, durch die folgende Beziehung angegeben werden: $I \left(t\right) = {I}_{0} \left(1-{e}^{- \frac{R}{L} t}\right)$ (2)

Hierbei entspricht R der Summe der parasitären Serienwiderstände der Induktivität L und des Bahnwiderstands des durchgeschalteten Transistors T (die dazwischenliegenden Leitungsbahnen werden hier idealisiert als nur einen vernachlässigbarem Widerstand aufweisend betrachtet) und U_{V} ist wieder die Versorgungsspannung, die zugleich dem Spannungsabfall über dieser Serienschaltung entspricht. l₀ ist eine maximale Stromstärke (Grenzstrom), der sich der Ladestrom l(t) mit der Zeit asymptotisch näher. Der Grenzstrom berechnet sich zu: ${I}_{0} = \frac{{U}_{V}}{R}$ (3)

Zur Vereinfachung der Gleichung (2) kann diese im Ursprung zum Zeitpunkt Zeit t = 0 durch deren Ableitung linearisiert werden: $\frac{dI \left(t\right)}{dt} = \frac{{I}_{0} R}{L} {e}^{- \frac{R}{L} t}$ (4)

Zum Zeitpunkt t = 0 vereinfacht sich diese Beziehung zu: $\frac{dI \left(0\right)}{dt} = \frac{{I}_{0} R}{L}$ (5)

Mit dem Einsetzen von (3) in (5) ergibt sich mit der Linearisierung zum Zeitpunkt t_{L}, an dem in die zweite Schaltungskonfiguration umgeschaltet wird, für den Strom l durch die Induktivität: $I \left({t}_{L}\right) \approx \frac{{U}_{V}}{L} {t}_{L}$ (6)

Die gespeicherte Energie *E_{L}* in der Induktivität L zum Zeitpunkt t = t_{L} ergibt sich zu: ${E}_{L} \left({t}_{L}\right) = \frac{1}{2} {LI}^{2} \left({t}_{L}\right)$ (7)

Korrespondierend dazu gilt für die Energie *E_{M}* der MEMS-Kapazität *C_{M},* wobei *U_{M}* die über *C_{M}* liegende Kondensatorspannung ist: ${E}_{M} = \frac{1}{2} {C}_{M} {U}_{M}^{2}$ (8)

Setzt man die beiden Gleichungen (7) und (8) gleich und ersetzt *I*(*t_{L}*) durch den Ausdruck aus der Gleichung (6), so ergibt sich für die Spannung *U_{M},* auf welche die MEMS-Kapazität *C_{M}* aufgrund des Energietransfers von der Induktivität L aufgeladen wird, zu: ${U}_{M} \approx \sqrt{\frac{1}{{LC}_{M}}} {U}_{V} {t}_{L}$ (9)

So skaliert die Spannung *U_{w}* über der MEMS-Kapazität *C_{M}* in guter Näherung proportional zu der Zeitdauer, in der der Transistor durchgeschaltet ist, ebenso proportional mit der Versorgungsspannung U_{V}, und wurzelförmig mit dem Kehrwert von Werten für die Induktivität L und die MEMS-Kapazität *C_{M}.* Diese Näherung ist insbesondere dann gültig, wenn die Summe aller parasitären Widerstände (z.B. Serienwiderstand der Spule, Serienwiderstand der MEMS-Kapazität C_{M} und Bahnwiderstände) absolut betrachtet vergleichsweise klein sind. Ansonsten führten diese zu einer schlussendlich geringeren Ladespannung der MEMS-Kapazität C_{M}, da die in der Spule gespeicherte Energie nicht nur in die MEMS-Kapazität transferiert, sondern zum Teil auch in Wärme umgewandelt wird.

Die Spannung *U_{M}* über der MEMS-Kapazität *C_{M}* kann somit zumindest näherungsweise als lineare Funktion der Zeitspanne *t_{L}* betrachtet werden. Da alle Komponenten innerhalb der Schaltung, insbesondere L und *C_{M},* bekannt sind, kann somit die Ausgangsspannung *U_{M}* allein über die steuerbare Einschaltzeit *t_{L}* des Transistors T eingestellt werden. Dadurch kann der Regler Reg wegfallen, was zu einer deutlichen Vereinfachung der Schaltung 200 gegenüber der herkömmlichen Schaltung 100 führt.

Der Schalter S₂ zum Entladen der MEMS-Kapazität C_{M} kann entweder entsprechend Fig. 1 parallel zu C_{M} geschaltet sein (dritter Strompfad) oder - wie abgebildet - in einem zur Versorgungsspannungsquelle zurückführenden vierten Strompfad (dann zur Kennzeichnung dieser unterschiedlichen Anordnung als Schalter S_{2'} bezeichnet). Die Versorgungsspannungsquelle (nicht aber der zweite Strompfad zwischen Induktivität und MEMS-Kapazität C_{M}) ist über einen Pufferkondensator C_{B} gepuffert, in dem die über den Schalter S_{2'} beim Entladen von C_{M} zurückfließenden Ladungen zwischengespeichert und für einen weiteren Aktivierungszyklus des Aktuators wiederverwendet werden können. So lässt sich der Wirkungsgrad der Schaltung 200 weiter steigern.

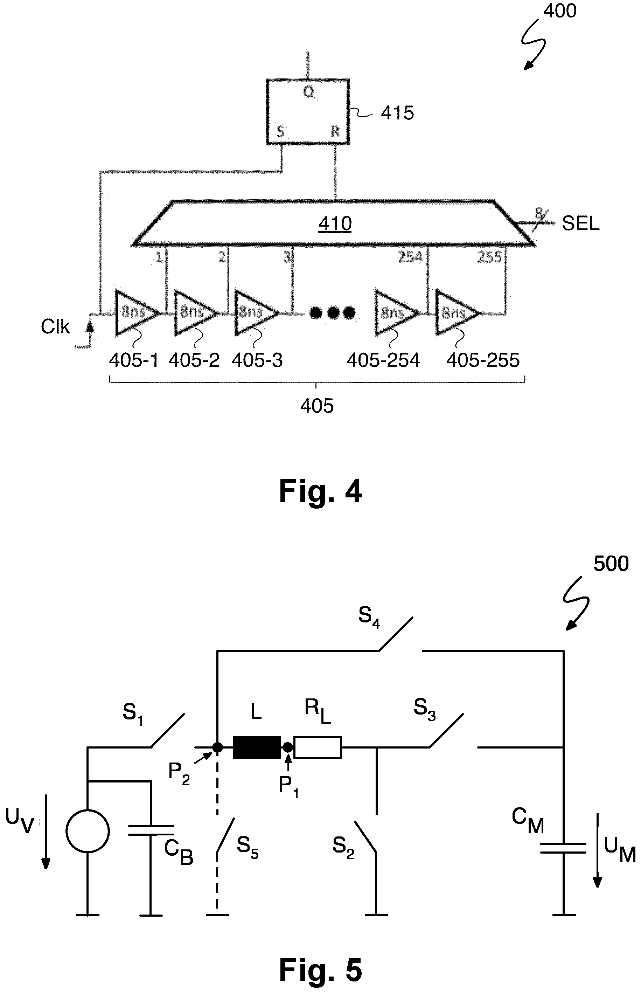

**Fig. 4** zeigt eine beispielhafte Ausführung 400 der Steuerungseinrichtung Ctrl zur Steuerung einer lösungsgemäßen Schaltung, insbesondere gemäß Fig. 2A. Sie dient dazu, die Einschaltzeit bzw. -dauer des Transistors T und somit auch die Ausgangsspannung U_{M} zu steuern und ist mit einer Verzögerungskette 405 mit mehreren hintereinander geschalteten Verzögerungsgliedern 405-1, ..., 405-n, einem Multiplexer 410 und einem Flip-Flop realisiert.

Im vorliegenden Beispiel ist n = 255 gewählt. Die Verzögerungsglieder 405-1, ...,405-255 können hierbei aus Standardzellen oder auch "customized", insbesondere anwendungsspezifisch, in analoger Schaltungstechnik ausgeführt werden. Die erforderliche Verzögerungsdauer jedes einzelnen Verzögerungsglieds lässt sich aus dem Quotienten der maximalnotwendigen Einschaltzeit und der Anzahl der Verzögerungsglieder errechnen. Im Beispiel wurde der Einfachheit halber für alle Verzögerungsglieder 405-1, ...,405-255 die gleiche Verzögerungsdauer von 8 ns gewählt.

Eine analoge Ausführung hat speziell den Vorteil, dass über eine Stromsteuerung die Verzögerungszeit jedes einzelnen Verzögerungsgliedes individuell eingestellt werden kann und somit für beliebige MEMS-Kondensatoren (mit unterschiedlichen Kapazitätswerten und Ausgangsspannungen) optimal einstellbar ist.

Jeder Takt eines an die Steuerungseinrichtung 400 angelegten Taktsignals CLK wird somit gleichmäßig entsprechend der Anzahl der Verzögerungsglieder 405-1, ...,405-255 unterteilt.

Durch ein an den Multiplexer 410 angelegtes Auswahlsignal SEL kann die gewünschte Stufe der Verzögerungskette ausgewählt werden, die auf den R-Eingang des RS-Flip-Flops 415 ausgegeben wird. Wenn das Taktsignal CLK auf dem Pegel "1" bzw. "high" liegt, schaltet das Ausgangssignal Q (z.B. mit dem Pegel "1") den Transistor T leitend. Sobald jedoch nachfolgend gemäß der ausgewählten Verzögerung das Ausgangssignal des Multiplexers 410 wechselt (z.B. auf den Pegel "1"), ändert sich das Ausgangssignal Q so (z.B. auf den Pegel "0"), dass damit der Transistor T gesperrt wird. Über die Auswahl der Verzögerung mittels des Auswahlsignals SEL lässt sich somit die Zeitdauer t_{L} einstellen, während der die Induktivität L mit magnetischer Energie "aufgeladen" wird. Da die Höhe der Spannung U_{M} über M EMS-Kapazität C_{M} wiederum von der Zeitdauer t_{L} abhängt, lässt sich mittels des Auswahlsignals SEL die die Höhe der Spannung U_{M} und somit die Aktivität des Aktuators steuern.

In **Fig. 5** ist als eine zweite beispielhafte Ausführungsform eine Schaltung 500 zum bipolaren Ansteuern eines Aktuators mit einem gesteuerten Hochsetzsteller dargestellt.

Bei der Schaltung 500, die eine Abwandlung bzw. Fortentwicklung der Schaltung 200 darstellt, ist die Schalteinrichtung des Weiteren eingerichtet, wiederholt und jeweils temporär in einem Zeitraum, in dem der zwischen einem ersten Pol der Induktivität L und der MEMS-Kapazität C_{M} liegende zweite Strompfad nicht durchgängig geschaltet ist, einen vierten Strompfad zwischen der MEMS-Kapazität und einem zum dem ersten Pol P₁ elektrisch gegenpoligen zweiten Pol P₂ der Induktivität L derart durchgängig zu schalten, dass die MEMS-Kapazität C_{M} dabei auf eine zweite Spannung mit einer zur Polarität der ersten Spannung entgegengesetzten Polarität aufgeladen wird.

Die Schalteinrichtung der Schaltung 500 weist zu diesem Zweck vier Schalter S₁ bis S₄ auf. Der Schalter S₁ liegt im Strompfad zwischen der Versorgungsspannung U_{V} und dem zweiten Pol P₂ der Induktivität L. Der Schalter S₂ liegt im ersten Strompfad zwischen dem ersten Pol P₁ der Induktivität L und Masse. Er kann insbesondere - wie in Fig 2A - durch einen Transistor T (oder mehrere Transistoren und/oder Dioden) realisiert sein. Dasselbe gilt auch für alle anderen Schalter. Der dritte Schalter S₃ liegt im zweiten Strompfad zwischen dem ersten Pol P₁ der Induktivität L und der MEMS-Kapazität C_{M}. Der vierte Schalter S₄ liegt in einem weiteren ("vierten") Strompfad zwischen der MEMS-Kapazität C_{M} und der Versorgungsspannung U_{V} bzw. deren Pufferkondensator C_{B} und entspricht dem Schalter S_{2'}, aus Fig. 2B.

Optional kann ein weiterer Schalter S₅ zwischen dem zweiten Pol P₂ und Masse vorgesehen sein.

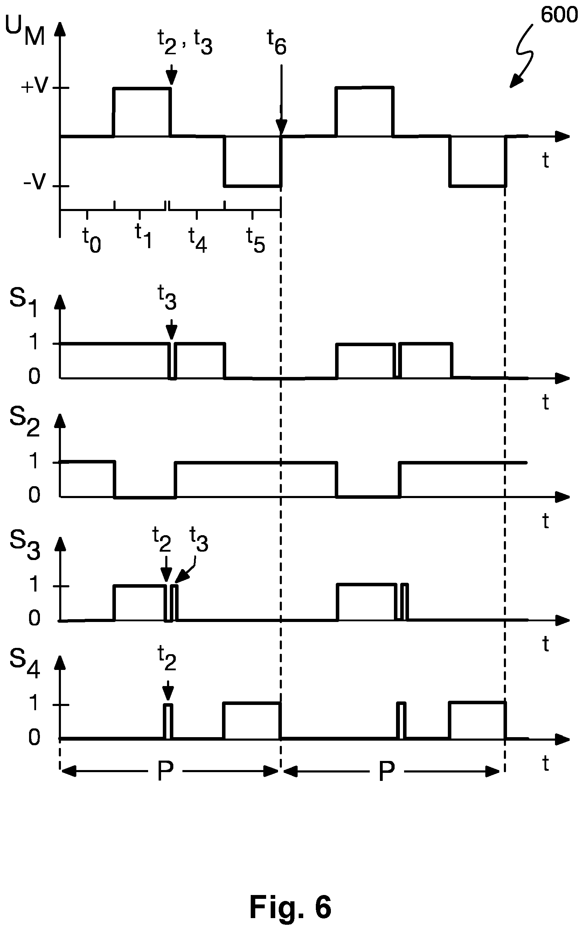

Die Funktionsweise der Schaltung 500 ist in **Fig. 6** anhand des zeitlichen Verlaufs 600 der Konfiguration der Schalteinrichtung der Schaltung 500, insbesondere der Schaltzustände ihrer einzelnen Schalter S₁ bis S₄, illustriert.

Die Schaltzustände der Schalteinrichtung werden durch eine Steuerung (nicht dargestellt) im zeitlichen Verlauf schrittweise gemäß der nachfolgenden Sequenz mit den aufeinanderfolgenden Zeitintervallen t₀ bis t₆ in verschiedene Schaltzustände zu versetzt, wobei in den Diagrammen "1" einen geschlossenen Schalter und "0" einen geöffneten Schalter anzeigt und die Sequenz wenigstens einmal durchlaufen wird:

| **Zeitintervall** | **U_{M}** | **S₁** | **S₂** | **S₃** | **S₄** |
|---|---|---|---|---|---|
| vor t₀ | Idle | 0 | 0 | 0 | 0 |
| t₀ | 0 (Ladevorgang Spule) | 1 | 1 | 0 | 0 |
| t₁ | +V | 1 | 0 | 1 | 0 |
| | Idle | 0 | 0 | 0 | 0 |
| t₂ | +V↦+V₁ | 1 | 0 | 0 | 1 |
| t₃ | +V₁↦0 | 0 | 1 | 1 | 0 |
| | Idle | 0 | 0 | 0 | 0 |
| t₄ | 0 (Ladevorgang Spule) | 1 | 1 | 0 | 0 |
| t₅ | -V | 0 | 1 | 0 | 1 |
| | Idle | 0 | 0 | 0 | 0 |
| t₆ | -V↦0 | 0 | 1 | 1 | 0 |

In Fig. 6 ist ein spezieller Fall gezeigt, bei dem diese Sequenz periodisch wiederholt wird (die Übergänge zwischen den aufeinander folgenden Perioden P sind durch vertikale gestrichelten Linien gekennzeichnet). Wie in der Tabelle dargestellt (aber in Fig. 6 nicht illustriert) wird nach jeder erfolgten Auf- oder Entladung der MEMS-Kapazität C_{M} bis zu einem Zeitpunkt, an dem die Induktivität L wieder geladen werden muss, ein Ruhezustand hergestellt, in dem alle Schalter geöffnet sind ("Idle"-Zustand) und die MEMS-Kapazität C_{M} "floatend" ist, d.h. dass sie mangels Verbindung mit einem definierten elektrischen Potenzial selbst kein definiertes elektrisches Potenzial aufweist. Dies dient dazu, zu verhindern, dass die in der MEMS-Kapazität C_{M} beim Aufladen gespeicherte Ladung wieder, insbesondere zur Versorgungsquelle hin, abfließt bzw. die gerade entladene MEMS-Kapazität C_{M} gleich wieder (teil-)geladen wird. Das heißt im Umkehrschluss auch, dass die Steuerungseinrichtung so ausgelegt sein sollte, dass der bzw. die relevanten Schalter (z.B. S₃) sofort geöffnet wird bzw. werden, sobald die Energie der Spule vollständig aufgebraucht wurde. Alternativ kann diese Funktion durch einen entsprechenden Aufbau des Schalters selbst mit übernommen werden.

Vor dem Zeitintervall t₀ sind alle Schalter geöffnet ("Idle"-Zustand) und die MEMS-Kapazität C_{M} hat daher kein definiertes elektrisches Potenzial (schwebend bzw. floating). Im Zeitintervall t₀ liegt die "erste" Schaltungskonfiguration vor, bei der nur die Schalter S₁ und S₂ geschlossen sind, sodass der erste Strompfad durch die Induktivität L geschlossen ist und aufgrund eines von der Versorgungsspannung U_{V} gespeisten Stroms entlang des ersten Strompfads in der Induktivität L ein Magnetfeld mit der zugehörigen magnetische Energie aufgebaut wird. Die Spule wird somit mit Energie "aufgeladen".

Beim Übergang zum nachfolgenden Zeitintervall t₁ wird bei weiterhin geschlossenem Schalter S₁ der Schalter S₂ geöffnet und stattdessen der Schalter S₃ geschlossen, sodass dann eine "zweite" Schaltungskonfiguration vorliegt, bei der der zweite Strompfad von einem ersten Pol der Induktivität L über den geschlossenen Schalter S₃ bis zur MEMS-Kapazität C_{M} durchgängig geschaltet ist, sodass die in der Induktivität L inzwischen gespeicherte magnetische Energie einen Stromfluss entlang des zweiten Strompfads bewirkt, mittels dem die MEMS-Kapazität C_{M} auf die positive Spannung U_{M} = +V aufgeladen wird.

Es folgt ein (nicht in Fig. 6 illustrierter) Idle-Zustand, bei dem alle Schalter geöffnet sind, um zu vermeiden, dass die in der MEMS-Kapazität C_{M} nun gespeicherte Ladung wieder zur Spannungsquelle für die Versorgungsspannung U_{V} abfließen kann.

Im weiter nachfolgenden Zeitintervall t₂ (welches optional ist) ist der Schalter S₃ wieder geöffnet und stattdessen der Schalter S₄ geschlossen, sodass über den Schalter S₄ ein weiterer Strompfad durchgängig geschaltet ist (entspricht insbesondere dem anspruchsgemäßen "vierten" Strompfad), über den die MEMS-Kapazität C_{M} zumindest anteilig in die Pufferkapazität C_{B} (zur Pufferung der Versorgungsspannung U_{V}) auf eine niedriger Spannung U_{M} = +V₁ entladen wird. So kann ein "Ladungsrecycling" in dem Sinne betrieben werden, dass ein Teil der Ladung der Pufferkapazität C_{B} für den nächsten Aufbau eines Magnetfelds in der Induktivität L erneut genutzt werden kann und so der Wirkungsgrad der Schaltung 500 erhöht werden kann.

Alternativ dazu kann durch Schließen der Schalter S₂ und S₄ bei geöffneten Schaltern S₁ und S₃ eine Ladungsrückgewinnung aus der MEMS-Kapazität C_{M} unmittelbar durch Bewirken eines entsprechenden Stroms durch die Induktivität L zum Aufbau magnetischer Energie in der Induktivität L genutzt werden (nicht illustriert).

Im Zeitintervall t₃ sind nur die Schalter S₂ und S₃ geschlossen, sodass die MEMS-Kapazität C_{M} darüber vollständig gegen Masse entladen werden kann (dieser Schritt kann bei der vorgenannten Alternative entfallen, das die MEMS-Kapazität C_{M} dort bereits im Zeitintervall t₂ entladen wird).

Es folgt wieder ein (nicht in Fig. 6 illustrierter) "Idle-Zustand, bei dem alle Schalter geöffnet sind, um zu vermeiden, dass die in der MEMS-Kapazität C_{M} nun wieder unkontrolliert (teil-)geladen wird.

Während des nachfolgenden Zeitintervalls t₄ sind nur die Schalter S₁ und S₂ geschlossen, so dass wie im Zeitintervall t₀ die Induktivität über den ersten Strompfad mit magnetischer Energie aufgeladen wird. Der Stromfluss durch die Induktivität L wird dabei aus der Versorgungsspannung U_{V} und anteilig aus der Pufferkapazität C_{B} gespeist.

Im Zeitintervall t₅ wird bei weiterhin geschlossenem Schalter S₂ der Schalter S₁ geöffnet und der Schalter S₄ geschlossen, sodass Ladung aus der MEMS-Kapazität C_{M} über S4 durch die Induktivität L und über S₂ abfließt, wobei aufgrund des Bestrebens der Induktivität L, den ursprünglichen Stromfluss durch sie aufrecht zu erhalten (Lenz'sche Regel), der Stromfluss anhält, bis die MEMS-Kapazität C_{M} auf einen negativen Spannungswert geladen wird, der betragsmäßig insbesondere dem positiven Spannungswert +V entsprechen und somit bei -V liegen kann.

Es folgtwieder ein (nicht in Fig. 6 illustrierter) Idle-Zustand, bei dem alle Schalter geöffnet sind, um zu vermeiden, dass die in der MEMS-Kapazität C_{M} nun gespeicherte Ladung wieder zur Spannungsquelle für die Versorgungsspannung U_{V} abfließen kann.

Im Zeitintervall t₆ sind schließlich wieder nur die Schalter S₂ und S₃ geschlossen, sodass die MEMS-Kapazität C_{M} darüber vollständig gegen Masse auf 0V entladen werden kann. Dann kann ein neuer Zyklus mit einem erneuten Durchlauf der Sequenz erfolgen.

Der optionale Schalter S₅ kann insbesondere wie folgt eingesetzt werden, um analog zur vorausgehend beschriebenen Ladungsrückgewinnung bei positiven Spannungen auch bei negativen Spannungen Ladungen zurückgewinnen zu können: Soll die MEMS-Kapazität C_{M} beispielsweise von -V auf 0 entladen werden, so können z.B. S₅ und S₃ geschlossen werden. Jetzt baut sich wieder ein Strom in der Induktivität L auf.

Ist die MEMS-Kapazität C_{M} leer, so können sofort S₅ und S₃ geöffnet und stattdessen S₁ und S₂ geschlossen werden, um den Strom in der Induktivität L weiter ansteigen zu lassen. Dann nimmt alles den oben bereits beschriebenen weiteren Verlauf.

### Beispielhafte Ausführungsformen der zweiten Schaltung

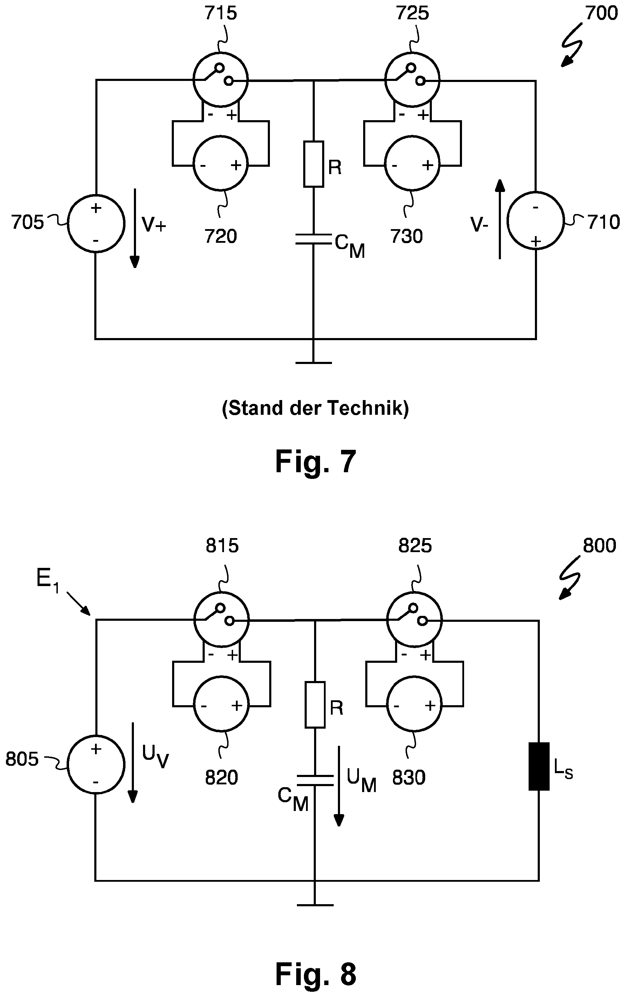

Es folgen nun des Weiteren Erläuterungen zu beispielhaften Ausführungsformen der zweiten Schaltung, wobei zunächst von der herkömmliche Schaltung 700 aus Fig. 7 ausgegangen wird:
Die Schaltung 700 aus Fig. 7 stellt eine sogenannte Halbbrückenschaltung dar. Sie verfügt über zwei Versorgungsspannungsquellen 705 und 710, die zueinander komplementäre Spannungen liefern. Der zentrale Schaltungsast der Schaltung 700 weist eine mittels der Halbbrückenschaltung zu treibende Komponente auf, im vorliegenden Beispiel einen kapazitiven MEMS-Aktuator, wie etwa einen Piezoaktor. Die MEMS-Kapazität des MEMS-Aktuators ist hier als C_{M} bezeichnet. Ein in der Realität auftretender Ohm'scher Widerstand des zentralen Schaltungsasts ist, hier im Sinne eines Ersatzschaltbilds, durch den Widerstand R repräsentiert, der im Rahmen der weiteren Erläuterungen jedoch keine Rolle spielt.

Des Weiteren weist die Schaltung zwei Schalteinrichtungen 715 und 725 auf, die jeweils durch eine zugeordnete Steuerspannungsquelle 720 bzw. 730 variabler Steuerspannung ansteuerbar sind, so dass in Abhängigkeit von dieser jeweiligen Steuerspannung die dieser zugeordnete Schalteinrichtung (z.B. Schalter oder Schalttransistor) 715 bzw. 725 einen Strompfad zwischen der zugeordneten Versorgungsspannungsquelle 705 bzw. 715 und der MEMS-Kapazität C_{M} durchgängig schaltet oder unterbricht. Durch alternierendes temporäres Durchgängigschalten der beiden Strompfade durch die Schalteinrichtungen 715 und 725 kann somit die MEMS-Kapazität C_{M} abwechselnd auf eine positive bzw. eine negative Spannung V+ bzw. V-umgeladen werden, wodurch der MEMS-Aktuator entsprechend eine korrespondierende alternierende Bewegung ausführen bzw. antrieben kann.

Diese Art der Schaltung ist aber nicht sehr energieeffizient. Im Mittel muss bei der Schaltung 700 bei ihrem Betrieb insgesamt die Leistung ${P}_{total} = {C}_{M} ⋅ {U}^{2} ⋅ f$ (10) durch die Versorgungsspannungsquellen 705 und 710 aufgebracht werden.

Dabei beschreibt hier C_{M} den Kapazitätswert der MEMS-Kapazität, U die Spitze-zu-Spitze-Spannung über der MEMS-Kapazität und f die Frequenz der sich einstellenden Rechteckspannung. Beim Beispiel eines Mikroscanners als MEMS mit einer typischen MEMS-Kapazität seines Aktuators zum Antrieb des Ablenkelements von 100 pF, einem Spannungshub von 200 V (±100 V) und einer Frequenz von 25 kHz ergäbe sich somit eine theoretische Leistungsaufnahme von 100 mW.

Ein erster Grund für die eher geringe Energieeffizienz der Schaltung 700 liegt darin, dass aufgrund des hier auftretenden, aus der allgemeinen Schaltungstechnik bekannten sog. "Kondensator-Paradoxons" oder "Zwei-Kondensatoren-Paradoxons" (vgl. https://en.wikipedia.org/wiki/Two_capacitor paradox) zumindest 50% der aufgenommenen Leistung beim Auf- bzw. Umladen der MEMS Kapazität C_{M} direkt in Wärme umgesetzt werden. Das ist auch dann der Fall, wenn der Leitungswiderstand (z.B. aber auch R) infinitesimal klein wird.

Ein zweiter Grund liegt darin, dass der verbleibende Anteil der zugeführten Leistung für den Aufbau der unterschiedlichen Energieniveaus in der MEMS-Kapazität C_{M}, d.h. für das alternierende Umladen, benötigt wird, wobei jedoch beim Umladen aus der MEMS-Kapazität C_{M} abfließende Ladung gegen Masse bzw. durch die Spannungsquellen abgeleitet wird, ohne zur weiteren Verwendung zurückgewonnen zu werden.

Fig. 8 zeigt eine erste beispielhafte Ausführungsform 800 der zweiten Schaltung, die ein bipolares Ansteuern des Aktuators, genauer der MEMS-Kapazität C_{M}, ermöglicht. Hier genügt jedoch eine einzige Versorgungsspannungsquelle 805, die in ihrem Aufbau insbesondere der Versorgungsspannungsquelle 705 entsprechen kann und eine Gleichspannung als Versorgungsspannung U_{V} der Schaltung 800 liefert, insbesondere an einem Einspeisungspunkt E₁. Typischerweise handelt es sich hierbei angesichts des Spannungsbedarfs des Aktuators um eine Hochspannungsquelle (im vorliegenden Kontext also um eine Spannungsquelle, die eine Versorgungsspannung liefern kann, die über den typischen Versorgungsspannungen von Logikschaltungen, insbesondere Halbleiterschaltungen, liegt). Die Versorgungsspannung kann betragsmäßig insbesondere größer als 10 V sein, insbesondere auch bei oder oberhalb von 100 V liegen.

Anstelle der zweiten Versorgungsspannungsquelle 710 ist in der Schaltung 800 dagegen eine Induktivität L_{S} ("Schwingkreisinduktivität") enthalten, die zusammen mit der MEMS-Kapazität C_{M} (und R) und einer Schalteinrichtung 825 einen Schwingkreis bildet. Die Schalteinrichtung 825 kann in ihrem Aufbau insbesondere einer der vorausgehend beschriebenen Schalteinrichtungen 715 und 725 entsprechen. Der Schwingkreis ist über eine Schalteinrichtung 815 mit dem von der Versorgungsspannungsquelle 805 gespeisten Einspeisepunkt E₁ elektrisch verbindbar, um bei geschlossener Schalteinrichtung 815 elektrische Energie von der Versorgungsspannungsquelle 805 in den Schwingkreis zu überführen.

Wäre die Schalteinrichtung 825 nicht vorhanden oder dauerhaft geschlossen, dann wäre die Schwingungsfrequenz des Schwingkreises durch seine gemäß der Beziehung (1) (vgl. oben) durch die Werte von C_{M} und L_{S} bedingten Resonanzfrequenz *f₀* gegeben.

Speziell im Fall von Mikroscannern, liegen typische Resonanzfrequenzen von Ablenkelementen (Spiegelplatten) im Bereich von bis zu maximal 100 kHz. Die Kapazität des piezoelektrischen Materials liegt typischerweise in einem Bereich bis zu ca. 150 pF. In erster Linie könnte man nun als Schwingkreisinduktivität L_{S} eine Spule mit geeignetem Induktivitätswert wählen, sodass die Resonanzfrequenz *f₀* des elektrischen Schwingkreises genau der Resonanzfrequenz des Ablenkelements entspricht.

Es zeigt sich jedoch, dass gemäß der Beziehung (1), nach L aufgelöst, unpraktikabel große Induktivitätswerte resultieren: ${L}_{S} = \frac{1}{{\left(2{πf}_{0}\right)}^{2} ⋅ {C}_{M}} = \frac{1}{{\left(2π⋅100kHz\right)}^{2} ⋅ 150 pF} = 16 , 9 mH$

Derart große Induktivitätswerte für L_{S} in Verbindung mit kleinen Wicklungswiderständen wären jedoch sehr platzaufwändig und daher in Produkten, in denen es auf eine möglichst kleine Bauform des MEMS ankommt, wie etwa in einer AR/VR-Brille, ungünstig. Je kleiner die Resonanzfrequenz *f₀* und/oder der Wert für C_{M} spezifiziert wird, desto größer wird die notwendige Induktivität L_{S}. Bei *f₀ =* 30 kHz und C_{M} = 100 pF würde sich für L_{S} bereits ein Wert von fast 300 mH ergeben.

Sofern L_{S}, insbesondere aus Platzgründen, klein gehalten werden muss, ist eine Schaltungsimplementierung mit einem klassischen, dauerhaft geschlossenen Schwingkreis daher ungünstig bis unmöglich.

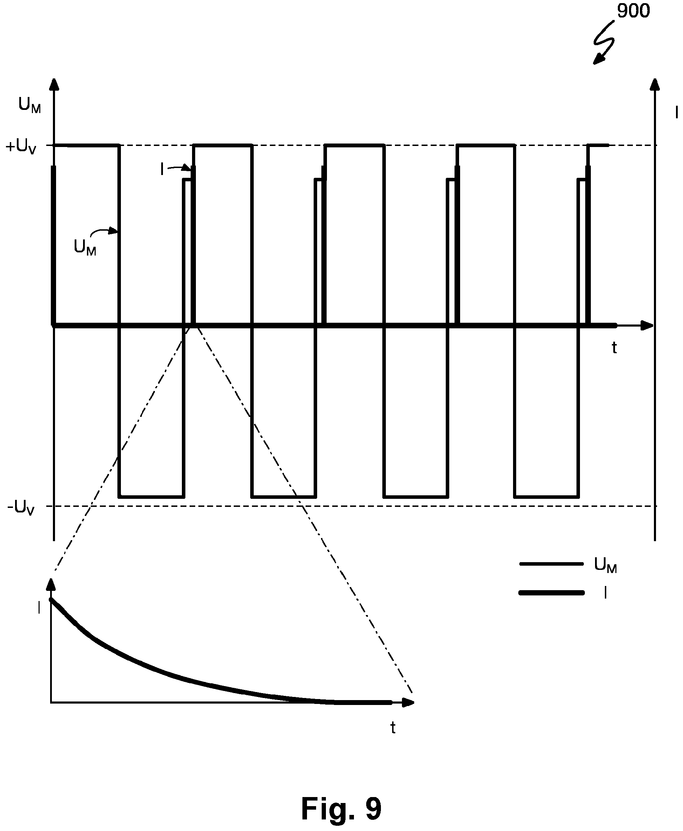

Wie in Fig. 9 anhand der Strom- und Spannungsverläufe 900 an der MEMS-Kapazität C_{M} illustriert, kann der Betrieb der Schaltung 800 daher insbesondere wie folgt erfolgen, wobei eine (nicht dargestellte) Steuerung, wie etwa ein computerprogrammgesteuerter Mikrocontroller oder eine festverdrahtete Steuerschaltung, zur Ansteuerung der Schalteinrichtungen zum Einsatz kommt: Zunächst wird bei geschlossener Schalteinrichtung 815 bei zugleich geöffneter Schalteinrichtung 825 ein Strompfad von der Versorgungsspannungsquelle 805 über die zunächst ungeladene MEMS-Kapazität C_{M} durchgängig geschaltet, um die MEMS-Kapazität C_{M} mittels eines Ladestroms l aus der Versorgungsspannungsquelle 805 erstmals auf einen Spannungspegel +V zu laden. Bei ausreichender Ladezeit steigt dabei die Spannung über der MEMS-Kapazität C_{M} bis auf die Höhe der Versorgungsspannung +V = U_{V} an (vgl. Detailausschnitt aus Fig. 9). Der Schwingkreis ist nun mit Energie versorgt und beginnt nach dem Öffnen der Schalteinrichtung 815 und Schließen der Schalteinrichtung 825 im Sinne einer gedämpften Schwingung zu schwingen. Diese Schwingung wird jedoch dadurch moduliert und somit hin zu einer niedrigeren Schwingungsfrequenz verändert, dass in jeder Schwingungsperiode die Schalteinrichtung 825 für eine bestimmten zeitlichen Anteil der Schwingungsperiode geöffnet wird, wenn die Spannung U_{M} an der MEMS-Kapazität C_{M} gerade ein Maximum erreicht und somit die im Schwingkreis vorhandene, zwischen C_{M} und L_{S} hin und her schwingende Energie momentan, zumindest weitgehend, als elektrische Energie in C_{M} gespeichert ist. Der zeitlichen Anteil an der Schwingungsperiode kann insbesondere etwa 50% sein, also etwa der halben Periodendauer entsprechen. Genauer wären es 50% abzüglich der Zeit, die der Schwingkreis zum Umladen zwischen zwei Spannungsniveaus braucht.

Zwischenzeitlich dem Schwingkreis, insbesondere am Widerstand R und den Leitungen durch, insbesondere Ohm'sche, Verluste verloren gegangene Energie (daher gedämpfte Schwingung), kann nun durch regelmäßiges temporäres Schließen der Schalteinrichtung 815 und Öffnen der Schalteinrichtung 825 durch erneutes Aufladen von C_{M} mit einem temporären, Ladestrom l kompensiert werden. Diese Nachladen erfolgt vorzugsweise dann, wenn die Spannung U_{M} über der MEMS-Kapazität C_{M} gerade ihren in der aktuellen Schwingungsperiode maximalen Wert erreicht. Dies muss jedoch nicht zwingend in jeder Schwingungsperiode bzw. nach jedem Umladen erfolgen. Vielmehr ist es auch möglich, das Nachladen nur nach zwischenzeitlichem mehrfachen Umladen bzw. erst nach mehreren Schwingungsperioden vorzunehmen, z.B. jedes m-te Mal, mit $m ∈ ℕ$, z.B. mit m = 2.

Das Nachladen kann allgemein sowohl mit einer positiv gepolten Hochvolt-Quelle zu Zeiten stattfinden, zu denen der Schwingkreis pausiert ist und die Spannung über dem MEMS gerade maximal ist, als auch mit einer negativ gepolten Hochvolt-Quelle zu Zeiten, zu denen der Schwingkreis pausiert ist und die Spannung über der MEMS-Kapazität C_{M} gerade minimal ist. In diesem Fall ergibt sich ein etwas gleichmäßigeres Spannungssignal über der MEMS-Kapazität C_{M}.

Der Schwingkreis wird somit regelmäßig pausiert, um einerseits seine Schwingungsfrequenz *f_{S}*, zu erhalten, die gegenüber der gemäß der Beziehung (1) (vgl. oben) durch die Werte von C_{M} und L_{S} bedingten Resonanzfrequenz *f*₀ des Schwingkreises (im dauerhaft geschlossenen Fall) herabgesetzt ist, und andererseits die bei der elektrischen Schwingung verlorene Energie nachzuladen.

Ein wesentlicher Vorteil dieser Schaltung ist dabei, dass aufgrund der direkten Einspeisung der Versorgungsspannung U_{V} in die MEMS-Kapazität C_{M} die nachteilige Wirkung des Kondensatorparadoxons in Anlehnung des Prinzip des gestuften, insbesondere adiabatischen Ladens reduziert und Leitungsverluste reduziert werden können. Zudem müssen die beim Umladen von C_{M} fließenden Ladungen nicht mehr einfach gegen Masse abgeleitet werden, sondern sie stehen der fortgesetzten elektrischen Schwingung im Schwingkreis weiterhin zur Verfügung. So lässt sich ein höherer Wirkungsgrad und somit eine höhere Energieeffizienz als bei der Schaltung 700 aus Fig. 7 erreichen.

Zudem können die Werte von C_{M} und L_{S} kleiner gewählt werden, als es im Falle eines klassischen Schwingkreises zur Erreichung der gewünschten Schwingungsfrequenz f_{S} erforderlich wäre. So können besonders platzsparende Schaltungsimplementierungen erreicht und auch die Abhängigkeiten von Bauteiltoleranzen eliminiert werden.

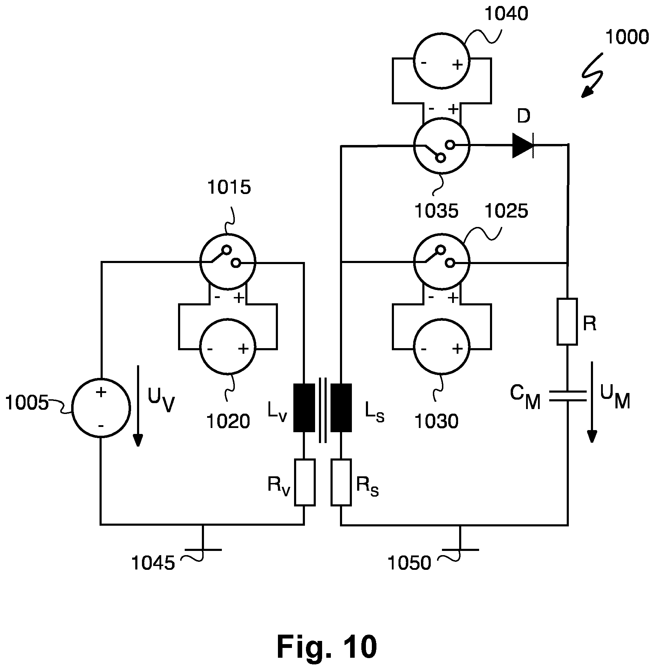

Fig. 10 illustriert eine zweite beispielhafte Ausführungsform 1000 der zweiten Schaltung, mit einem pausierbaren Schwingkreis sowie mit einer über ein gekoppeltes Spulenpaar induktiv an den Schwingkreis gekoppelten Hochspannungsquelle 1005 zur Bereitstellung einer Versorgungsspannung U_{V} für die Schaltung 1000. Die Spannungsquelle 1005 kann alternativ, je nach Windungsverhältnis des Spulenpaares, auch eine Niederspannungsquelle sein.

Konkret weist die Schaltung 1000 zwei galvanisch entkoppelte Schaltungsteile, vorzugsweise einschließlich entkoppelter erster und zweiter Massen 1045 und 1050, auf, die über ein aus einer ersten Kopplungsspule L_{V} und einer zweiten Kopplungsspule L_{S} bestehendes Spulenpaar induktiv gekoppelt sind. Die zweiten Kopplungsspule L_{S} stellt zugleich die Schwingkreis-Induktivität des Schwingkreises dar. Die Kopplungsspulen weisen zudem jeweils einen Ohm'schen Widerstand R_{V} bzw. R_{S} auf, der hier jeweils im Sinne eines Ersatzschaltbilds dargestellt ist.

Der erste Schaltungsteil weist eine Schaltungsschleife auf, die neben der Hochspannungsquelle 1005 und der ersten Kopplungsspule L_{V} (mit R_{V}) noch eine erste Schalteinrichtung 1015 mit einer zugeordneten Steuerspannungsquelle 1020 zu ihrer zeitlich variablen Ansteuerung enthält. In Abhängigkeit vom momentanen Schaltzustand der Schalteinrichtung 1015 ist die Schleife und somit der Strompfad durch die erste Kopplungsspule L_{V} geschlossen oder unterbrochen, so dass sich über die Steuerspannungsquelle 1020 die induktive Wirkung der ersten Kopplungsspule L_{V} und somit eine induktive Energieübertragung auf die zweite Kopplungsspule L_{S} im Schwingkreis steuern lässt.

Der Schwingkreis weist wiederum neben der als Schwingkreisinduktivität vorgesehenen zweiten Kopplungsspule L_{S} die anzusteuernde MEMS-Kapazität C_{M} eines MEMS-Aktuators (nebst deren Ohm'schen Widerstand R) sowie eine zweite Schalteinrichtung 1025 mit einer zugeordneten Steuerspannungsquelle 1030 zu ihrer zeitlich variablen Ansteuerung auf. Entsprechend der Schalteinrichtung 825 aus Fig. 8, kann mit der zweiten Schalteinrichtung 1025 der Schwingkreis pausiert werden.

Zusätzlich weist der Schwingkreis noch einen parallel zur zweite Schalteinrichtung 1025 geschalteten Schaltungsast mit einer Diode D und einer dritten zweite Schalteinrichtung 1035 mit einer zugeordneten Steuerspannungsquelle 1040 zu ihrer zeitlich variablen Ansteuerung auf.

Sind die Schalteinrichtungen 1015 und 1035 geöffnet, so dass sie die durch sie verlaufenden Strompfade unterbrechen, während die Schalteinrichtung 1025 geschlossen ist, ist der Schwingkreis geschlossen und "schwingt". Wenn jedoch die dabei auftretenden Energieverluste wieder ausgeglichen werden sollen (vgl. Fig. 9), dann werden die Schalteinrichtungen 1015 und 1035 geschlossen und die Schalteinrichtung 1025 geöffnet.

Nun kann durch einen einmaligen Strompuls (oder durch mehrere aufeinanderfolgende Strompulse bei entsprechendem mehrfachen Schließen und Öffnen der Schalteinrichtung 1015, ein zeitliche variabler Strom, insbesondere Wechselstrom, durch die erste Kopplungsspule L_{V} generiert werden, der durch induktive Energieübertragung über das Spulenpaar einen Induktionsstrom im zweiten Schaltungsteil bewirkt, der über die Schalteinrichtung 1035 verläuft und über die Diode D gleichgerichtet wird. So kann die MEMS-Kapazität C_{M} mit Gleichstrom (der zeitlich variabel sein kann) nachgeladen werden. Dies erfolgt während einer Zeitspanne, in der die aus der vorangegangenen Schwingung im Schwingkreis resultierende Spannung U_{M} über der MEMS-Kapazität C_{M} maximal und gleichpolig ist, wie die in der zweiten Kopplungsspule L_{S} generierte Induktionsspannung. Wird die Richtung der Diode umgedreht, so ergibt sich analog dazu die Möglichkeit, den Schwingkreis "nachzuladen", wenn die Spannung über der MEMS-Kapazität gerade minimal ist. Durch einen zusätzlichen Strompfad besteht darüber hinaus auch die Möglichkeit der bipolaren Nachladung.

Anstelle der Gleichspannungsquelle 1005 kann auch eine Wechselspannungsquelle eingesetzt werden, so dass das Erzeugen von Gleichstrompulsen zur Erzeugung eines zeitlich variierenden Stroms durch die erste Kopplungsspule L_{V} entfallen kann.

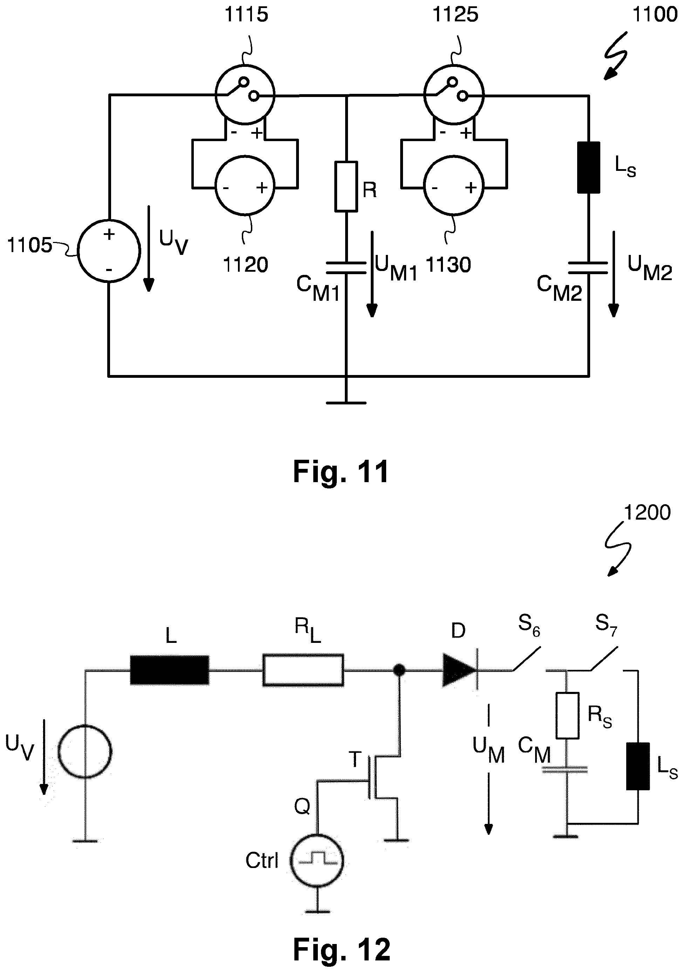

**Fig. 11** illustriert eine dritte beispielhafte Ausführungsform 1100 der zweiten Schaltung mit einem pausierbaren Schwingkreis, die aus der Schaltung 800 aus Fig. 8 hervorgeht, indem die dortige einzige Schwingkreis-Kapazität und zugleich MEMS-Kapazität C_{M} auf zwei separate MEMS-Kapazitäten C_{M1} und C_{M2} aufgeteilt wird. In der Schaltung 1100 entsprechen im Hinblick auf einen Vergleich mit der Schaltung 800 die Versorgungsspannungsquelle 1105 der Versorgungsspannungsquelle 805, und die Schalteinrichtungen 1115 und 1125 (mit zugeordneten Steuerspannungsquellen 1120, 1130) den Schalteinrichtungen 815 bzw. 825 (mit zugeordneten Steuerspannungsquellen 820 bzw. 830).

Aufgrund der Aufteilung der Schwingkreis-Kapazität auf die zwei separaten MEMS-Kapazitäten C_{M1} und C_{M2} in der gezeigten Anordnung, bei der die Schwingkreis-Induktivität LS und die Schalteinrichtung 1125 zwischen die beiden MEMS-Kapazitäten C_{M1} und C_{M2} geschaltet sind, ergeben sich beim (pausierbaren) Schwingen des Schwingkreises Spannungen U_{M1} bzw. U_{M2} an den MEMS-Kapazitäten C_{M1} und C_{M2}, die gegeneinander phasenverschoben sind und speziell bei gleichen Kapazitätswerten eine gleiche Amplitude aufweisen können. Die MEMS-Kapazitäten C_{M1} und C_{M2} können insbesondere Teil eines selben MEMS-Aktuators sein, sodass dessen ein differenzieller Antrieb ermöglicht ist. Beispielsweise können die MEMS-Kapazitäten C_{M1} und C_{M2} jeweils als Bestandteils eines Piezoaktors derart konfiguriert sein, dass sie, um insbesondre 180°, phasenversetzt in entgegengesetzte Richtungen wirkende piezoelektrische Kräfte bewirken.

### Beispielhafte Ausführungsformen für eine Kombination von erster Schaltung und zweiter Schaltung

Wie schon erwähnt, können die vorausgehend eingeführten Schaltungstypen "erste Schaltung" und "zweite Schaltung" auch vorteilhaft kombiniert werden. Während es dabei die erste Schaltung insbesondere erlaubt, für den Betrieb von Aktuatoren, insbesondere MEMS-Aktuatoren, erforderliche hohe Spannungen auch ohne Verwendung einer Hochspannungsquelle als solche bereitzustellen, und stattdessen eine Niederspannungsquelle, die insbesondere durch eine Primärbatterie oder Sekundärbatterie eines mobilen Geräts gegeben sein kann, zu verwenden, erlaubt die zweite Schaltung insbesondere eine platzsparende Bauform der Schaltung. Zudem dienen beide Schaltungen einer Steigerung der energetischen Effizienz.

**Fig. 12** illustriert eine erste beispielhafte Ausführungsform 1200 einer solchen kombinierten Schaltung zur Ansteuerung eines Aktuators, insbesondere eines MEMS-Aktuators, zum Antrieb einer Schwingungsbewegung in einem MEMS.

Die Schaltung 1200 kann als Fortentwicklung bzw. Variante der ersten Schaltung aus Fig. 2A betrachtet werden, so dass im Folgenden nur noch auf die Unterschiede dazu eingegangen wird.

Ein wesentlicher Unterschied besteht darin, dass in der Schaltung 1200 entsprechend dem Konzept der zweiten Schaltung ein pausierbarer Schwingkreis mit der MEMS-Kapazität C_{M} als Schwingkreis-Kapazität enthalten ist. Der Schwingkreis enthält zudem eine Schwingkreis-Induktivität L_{S} sowie eine Schalteinrichtung S₇ zum temporären Unterbrechen (pausieren) des Schwingkreises.

Zum Nachladen der MEMS-Kapazität C_{M} wird, wenn sie ihren maximalen Spannungswert im Rahmen der aktuellen Schwingungsperiode erreicht hat, der Schwingkreis mittels der Schalteinrichtung S₇ unterbrochen (pausiert) und durch Schließen der weiteren Schalteinrichtung S₆ ein Strompfad zwischen der im linken Teil der Fig. 12 dargestellten Hochsetzstellerschaltung und dem Schwingkreis, insbesondere der MEMS-Kapazität C_{M}, geschlossen.

Das Versorgen des Schwingkreises mit Energie kann hier somit allein mittels einer Niederspannungsquelle zur Bereitstellung der Versorgungsspannung U_{V} erfolgen, ohne dass eine Hochspannungsquelle erforderlich wäre.

Die Rückführungsschleife über die Schalteinrichtung S_{2'} sowie die Pufferkapazität C_{B} aus der Schaltung 200 aus Fig. 2A können zudem entfallen, da die Energie im Schwingkreis bis auf die typischen, insbesondere Ohm'schen, Verluste im Wesentlichen erhalten wird, sodass eine Pufferung nicht mehr erforderlich ist.

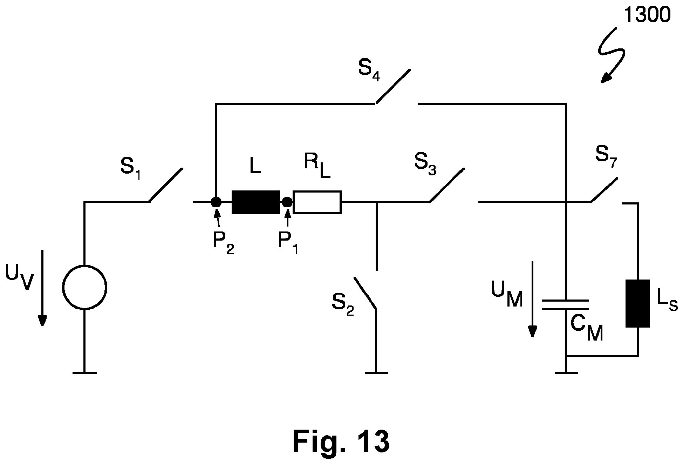

**Fig. 13** illustriert eine zweite beispielhafte Ausführungsform 1300 einer kombinierten Schaltung zur Ansteuerung eines Aktuators, insbesondere eines MEMS-Aktuators, zum Antrieb einer Schwingungsbewegung in einem MEMS.

Die Schaltung 1300 kann als Fortentwicklung bzw. Variante der ersten Schaltung aus Fig. 5 betrachtet werden, so dass im Folgenden nur noch auf die Unterschiede dazu eingegangen wird.

Ein wesentlicher Unterschied besteht darin, dass in der Schaltung 1300 wiederum ein pausierbarer Schwingkreis mit der MEMS-Kapazität C_{M} als Schwingkreis-Kapazität und einer Schwingkreis-Induktivität L_{S} sowie einer Schalteinrichtung S₇ zum temporären Unterbrechen (pausieren) des Schwingkreises enthalten ist.

Zum Nachladen der MEMS-Kapazität C_{M} wird einerseits, wenn sie ihren maximalen positiven Spannungswert im Rahmen der aktuellen Schwingungsperiode erreicht hat, der Schwingkreis mittels der Schalteinrichtung S₇ unterbrochen (pausiert) und durch Schließen zumindest einer der Schalteinrichtungen S₃ und S₄ wird ein Strompfad zwischen der im linken Teil der Fig. 13 dargestellten Hochsetzstellerschaltung und dem Schwingkreis, insbesondere der MEMS-Kapazität C_{M}, geschlossen. Die Hochsetzstellerschaltung ist dabei so bezüglich ihrer Schalterstellungen konfiguriert (z.B.: S₁ und S₃ geschlossen, S₂ und S₄ offen oder: S₁ und S₄ geschlossen, S₂ und S₃ offen), dass sie eine Versorgungsspannung an den Schwingkreis, bzw. genauer die MEMS-Kapazität C_{M}, liefert, die gleichpolig zur (positiven) Spannung U_{M} über der MEMS-Kapazität C_{M} ist.

Andererseits kann zum (zusätzlichen) Nachladen der MEMS-Kapazität C_{M}, wenn sie ihren maximalen negativen Spannungswert im Rahmen der aktuellen Schwingungsperiode erreicht hat, der Schwingkreis wieder mittels der Schalteinrichtung S₇ unterbrochen (pausiert) und durch Schließen zumindest einer der Schalteinrichtungen S₃ und S₄ wird ein Strompfad zwischen der Hochsetzstellerschaltung und dem Schwingkreis, insbesondere der MEMS-Kapazität C_{M}, geschlossen. Die Hochsetzstellerschaltung ist dabei so bezüglich ihrer Schalterstellungen konfiguriert (z. B: S₂ und S₄ geschlossen, S₁ und S₃ offen oder: S₂ und S₃ geschlossen, S₁ und S₄ offen), dass sie eine Versorgungsspannung an den Schwingkreis, bzw. genauer die MEMS-Kapazität C_{M}, liefert, die gleichpolig zur (negativen) Spannung U_{M} über der MEMS-Kapazität C_{M} ist.

Auch bei der Schaltung 1300 kann das Versorgen des Schwingkreises mit Energie allein mittels einer Niederspannungsquelle zur Bereitstellung der Versorgungsspannung U_{V} erfolgen, ohne dass eine Hochspannungsquelle erforderlich wäre. Zudem kann auch die Pufferkapazität C_{B} aus der Schaltung 500 aus Fig. 5 wieder entfallen, da die Energie im Schwingkreis bis auf die typischen, insbesondere Ohm'schen, Verluste im Wesentlichen erhalten wird, sodass eine Pufferung nicht mehr erforderlich ist.

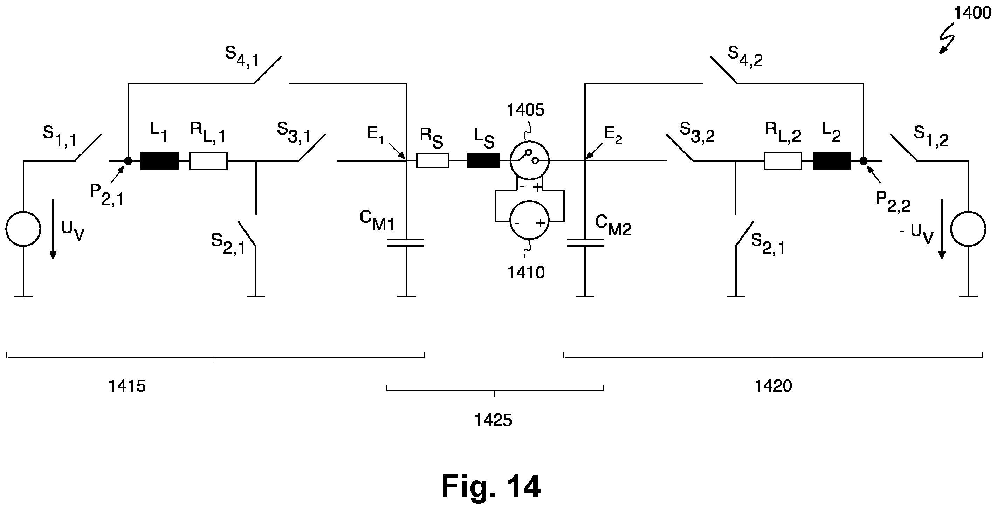

**Fig. 14** zeigt eine dritte beispielhafte Ausführungsform 1400 einer Schaltung in der die Konzepte der ersten Schaltung und der zweiten Schaltung kombiniert sind, um eine Schaltung zur bipolaren und differentiellen Ansteuerung eines MEMS-Aktuators, insbesondere Mikroscanners, zu bilden.

Die Schaltung 1400 weist neben einem Schwingkreis 1425, der mittels einer Schalteinrichtung 1405 unterbrochen werden kann und somit pausierbar ist, zwei Hochsetzstellerschaltungen 1415 und 1420 auf, die hier beispielhaft jeweils dem Konzept der Schaltung aus Fig. 13 entsprechen und die dazu dienen, zwei verschiedenpolige, hochgesetzte Versorgungsspannungen +U_{V} bzw. -U_{V} für den pausierbaren Schwingkreis 1425, je eine an einem zugeordneten Einspeisungspunkt E₁ bzw. E₂, bereitzustellen.

Das Nachladen der MEMS-Kapazitäten C_{M1} bzw. C_{M2} erfolgt wiederum vorzugsweise dann, wenn sie ihren jeweils zur zugeordneten Versorgungsspannung gleichpoligen, absolut betrachtet maximalen Spannungswert im Rahmen der aktuellen Schwingungsperiode erreicht haben. Dabei ist der Schwingkreis mittels einer Schalteinrichtung 1415 mit zugeordneter Steuerspannungsquelle 1420 temporär unterbrochen (pausiert). Die erste MEMS-Kapazität C_{M1} wird somit in einer ersten Polung (+) geladen während zugleich die zweite MEMS-Kapazität C_{M2} in einer zur ersten Polung entgegengesetzten Polung (-) geladen wird. Die Funktionsweise der Schaltung ist hinsichtlich jeder einzelnen der Polungen identisch zu der aus Fig. 13, wobei hier bei den Bezugszeichen ein weiterer Index 1 bzw. 2 eingeführt wird, um die Komponenten der beiden, insbesondere identisch ausführbaren, Hochsetzsteller 1415 und 1420 zu unterscheiden.

Die Ansteuerung der Schaltung 1400 ist so ausgebildet, dass während die Hochsetzsteller 1415 und 1420 arbeiten, die Schalteinrichtung 1405 geöffnet ist, sodass beide Hochsetzsteller 1415 und 1420, jeweils jeder für sich, separat arbeiten können, um insgesamt die MEMS-Kapazitäten C_{M}, und C_{M2} auf zueinander entgegengesetzte Spannungsniveaus aufzuladen. Wird danach im Anschluss der Schwingkreis aktiviert, werden beide Hochsetzsteller 1415 und 1420 in den "Idle"-Zustand versetzt, sodass sie die Funktion des dann schwingenden Schwingkreises 1425 nicht beeinträchtigen.

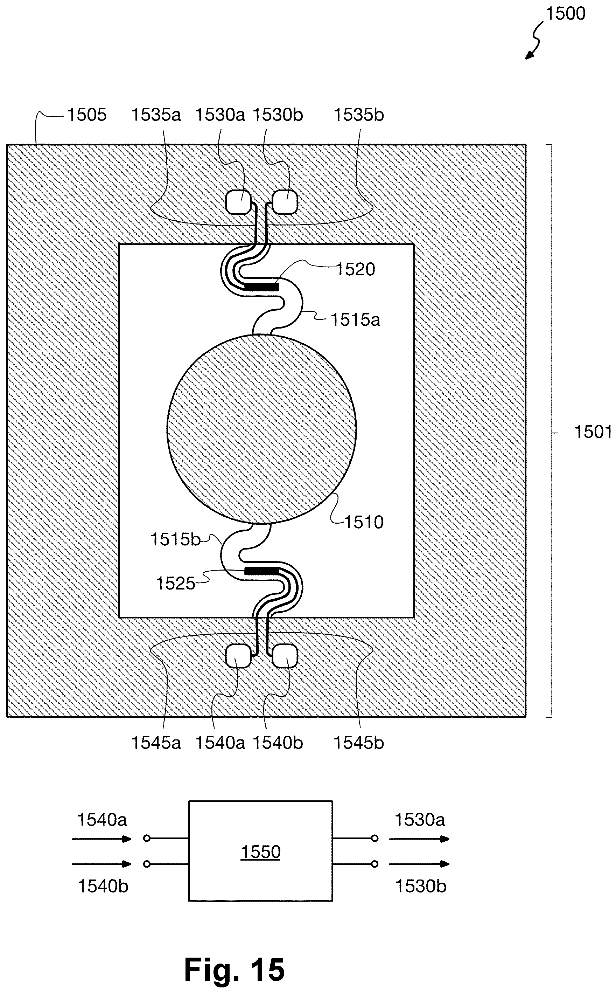

In Fig. **15** ist schematisch ein MEMS 1500 dargestellt, das ein Mikroscannersystem mit einem Mikroscanner 1501 aufweist. Der Mikroscanner 1501 weist der eine aus einem Halbleitersubstrat gefertigte Tragestruktur 1505 in Form eines Rahmens auf (Chiprahmen), der ein Ablenkelement (Spiegel) 1510 allseitig umgibt, dessen Basis aus demselben Halbleitersubstrat gefertigt ist wie die Tragestruktur 1505. Das Ablenkelement 1510 ist mittels einer oder mehrerer Federelemente, im vorliegenden Beispiel sind dies die beiden an gegenüberliegenden Seiten des Ablenkelements 1510 ansetzenden Federelemente 1515a und 1515b, an der Tragestruktur 1505 aufgehängt. Diese Aufhängung ist so ausgebildet, dass das Ablenkelement 1055 zumindest um eine Schwingungsachse rotatorisch oszillieren kann. Diese Schwingungsachse verläuft dabei entlang der (im Bild der Fig. 15 vertikal verlaufenden) Gerade durch die beiden Ansatzpunkte der Federelemente 1515a und 1515b am Ablenkelement 1510. Bei geeigneter Anregung ist es auch möglich, eine Schwingung um eine zweite, zur ersten Schwingungsachse orthogonale, im Bild der Fig. 15 also horizontale, Schwingungsachse anzuregen. Insbesondere zur Förderung einer solchen zweidimensionalen Oszillation können anstelle der hier dargestellten Aufhängung mit zwei gegenüberliegenden meanderförmigen Federelementen auch andersartig geformte und angeordnete Federelemente vorgesehen sein, insbesondere mehrere spiralförmige.

Auf jedem der Federelemente 1515a und 1515b befindet sich ein Piezoelement 1520 bzw. 1525, wobei sich diese Piezoelemente bezüglich ihres Piezomaterials und ihrer Aufgaben unterscheiden.

Das erste Piezoelement 1520 dient als Piezoaktor zum Antrieb der Oszillationsbewegung des Ablenkelements 1510 und ist daher auf Basis eines ersten Piezomaterials, wie etwa PZT, als Dielektrikum ausgebildet, welches einen besonders starken Piezoeffekt aufweist. Die durch das Piezomaterial voneinander separierten Elektroden des Piezoelements 1520 bilden zugleich die Elektroden seiner MEMS-Kapazität C_{M}. Das erste Piezoelement 1520 ist somit bei geeigneter Wahl der Federstärken der Federelemente 1515a und 1515b geeignet, insbesondere auch große Auslenkungen und somit Scanwinkel des Mikroscanners 100, insbesondere bis hin zu ± 90° (optischer Scanwinkel) oder sogar mehr, zu ermöglichen.

Das zweite Piezoelement 1525 dient dagegen als Piezosensor zur Messung und somit Bestimmung der zeitabhängigen Lage, d. h. konkret der Orientierung bzw. Phasenlage der Oszillation, des Ablenkelements 1510.

In Fig. 15 sind zudem für beide Piezoelemente 1520 und 1525 die entsprechenden Anschlussleitungen 1535a, b bzw. 1545a, b sowie daran gekoppelte Anschlusspads (Bondpads) 1530a, b bzw. 1540a, b zur Herstellung einer jeweiligen elektrischen Verbindung mit einer externen Antriebs- bzw. Messelektronik, z.B. via Drahtbonds, eingezeichnet. Es ist auch denkbar, dass neben den beiden dargestellten weitere Piezoelemente als Piezoaktoren oder Piezosensoren vorgesehen sind.

Als Basis dient ein SOI (Silicon-on-Insulator) Substrat. Auf diesem Substrat wird ein SiO₂ oder eine anderweitige elektrische Passivierung erzeugt, auf welcher die piezoelektrischen Schichtstapel aufgebracht werden. Die piezoelektrischen Schichtstapel bestehen dabei aus einer Bodenelektrode, meist Metall, dem piezoelektrischen Material, und einer Topelektrode, meist Metall. Zusätzlich kommt eine weitere elektrische Passivierung zum Einsatz zwischen Top- und Bodenelektrode zum Einsatz, um ein elektrisches Kurzschließen zu verhindern.

Zur Ansteuerung des ersten Piezoelements 1520 (und optional zur Verarbeitung von Messignalen des zweite Piezoelements 1525) weist das MEMS 1500 zusätzlich eine Schaltung 1550 gemäß einem der vorgenannten schaltungsbezogenen Aspekte der vorliegenden Lösung, z.B. gemäß einer der Figuren 2A oder 5 oder 12 bis 14. Je nach verwendeter Schaltung können die Piezoelemente nicht- differenziell oder differenziell ausgeführt sein.

### BEZUGSZEICHENLISTE

- 100: herkömmliche geregelte Hochsetzsteller-Schaltung
- 200: erste (unipolare) Ausführungsform einer lösungsgemäßen Schaltung
- 205: Vergleich der Schaltungen 100 und 200
- 300: zeitlicher Verlauf des Stroms durch die Induktivität L während der ersten Schaltungskonfiguration
- 400: Ausführungsform einer Steuerungseinrichtung Ctrl
- 405: Verzögerungskette
- 405-x: Verzögerungsglieder der Verzögerungskette 405
- 410: Multiplexer
- 415: RS-Flip-Flop
- 500: zweite (bipolare) Ausführungsform einer lösungsgemäßen Schaltung
- 600: zeitlicher Verlaufs der Konfiguration der Schalteinrichtung der Schaltung 500
- 700: herkömmliche Halbbrücken-Schaltung
- 705, 710: Versorgungsspannungsquellen
- 715, 725: Schalteinrichtungen
- 720, 730: Steuerspannungsquellen
- 800: erste beispielhafte Ausführungsform der zweiten Schaltung
- 805: Versorgungsspannungsquelle
- 815, 825: Schalteinrichtungen
- 820, 830: Steuerspannungsquellen
- 900: Strom- und Spannungsverläufe an der MEMS-Kapazität der Schaltung 800
- 1000: zweite beispielhafte Ausführungsform der zweiten Schaltung
- 1005: Versorgungsspannungsquelle
- 1015, 1025: Schalteinrichtungen
- 1020, 1030: Steuerspannungsquellen
- 1035: weitere Schalteinrichtung
- 1040: Steuerspannungsquelle für Schalteinrichtung 1035
- 1045: erste Masse
- 1050: zweite Masse
- 1100: dritte beispielhafte Ausführungsform der zweiten Schaltung
- 1105: Versorgungsspannungsquelle
- 1115, 1125: Schalteinrichtungen
- 1120, 1130: Steuerspannungsquellen
- 1200: erste beispielhafte Ausführungsform einer kombinierten Schaltung
- 1300: zweite beispielhafte Ausführungsform einer kombinierten Schaltung
- 1400: dritte beispielhafte Ausführungsform einer kombinierten Schaltung
- 1405: Schalteinrichtung
- 1410: Steuerspannungsquelle für Schalteinrichtung 1405
- 1415: erster Hochsetzsteller
- 1420: zweiter Hochsetzsteller
- 1425: Schwingkreis
- 1500: MEMS
- 1501: Mikroscanner
- 1505: Tragestruktur (Chiprahmen)
- 1510: Ablenkelement (Spiegel)
- 1515a: erstes Federelement
- 1515b: zweites Federelement
- 1520: erstes Piezoelement, Piezoaktor
- 1525: zweites Piezoelement, Piezosensor
- 15530a, b: Anschlusspads für das erste Piezoelement
- 135a, b: Anschlussleitungen für das erste Piezoelement
- 1540a, b: Anschlusspads für das zweite Piezoelement
- 1545a, b: Anschlussleitungen für das zweite Piezoelement

- C: Pufferkapazität in herkömmlicher Schaltung
- C_{B}: Pufferkondensator für Versorgungsspannungsquelle
- C_{M}: MEMS-Kapazität
- C_{M1}, C_{M2}: separate MEMS-Kapazitäten
- Clk: Taktsignal (Clock)
- Ctrl: Steuerung bzw. Steuerungseinrichtung
- D: Diode
- E₁, E₂: Einspeisungspunkte für elektrische Energie
- l: Ladestrom
- l₀: Grenzstrom
- L: Induktivität, insbesondere Booster-Induktivität
- L_{S}: Schwingkreisinduktivität, zweite Kopplungsinduktivität
- L_{V}: erste Kopplungsinduktivität
- OP: Operationsverstärker

- P: Periode bzw. Periodendauer
- P₁: erster Pol der Induktivität L
- P₂: zweiter Pol der Induktivität L
- Q: Ausgangssignal von Ctrl
- R, S: Eingänge des RS-Flip-Flops 415
- Reg: Regler
- R₁, R₂: Ohm'sche Widerstände, die Spannungsteiler bilden
- R_{L}, R_{L1}, R_{L2}: Ohm'scher Widerstand der zugeordneten Induktivität L, L₁ bzw. L₂
- R_{S}, R_{V}: Ohm'sche Widerstände der Kopplungsinduktivitäten, insbesondere Ohm'scher Widerstand im Schwingkreis gemäß Ersatzschaltbild
- S₁- S₇: Schalteinrichtungen, insbesondere Schalttransistoren
- SEL: Auswahlsignal
- T: Transistor
- t: Zeitvariable
- t₀,...,t₆: Zeitintervalle
- U_{A}: Spannung über Pufferkapazität C
- U_{M}: Spannung über MEMS-Kapazität
- U_{V}: Versorgungsspannung bzw. Versorgungsspannungsquelle
- V_{ref}: Referenzspannung
- +V, -V: alternierende Spannungspegel von U_{M}

## Patentansprüche

1. Schaltung zur Ansteuerung eines Aktuators zum Antrieb einer Schwingungsbewegung zumindest einer beweglichen Komponente eines mikroelektromechanischen Systems, MEMS, wobei:
die Schaltung eine Hochsetzstellerschaltung (200) mit einer Induktivität (L), einer elektrischen MEMS-Kapazität (CM) und einer mittels einer Steuerung ansteuerbaren erste Schalteinrichtung aufweist;
die MEMS-Kapazität derart als Bestandteil eines Aktuators ausgebildet ist, dass sie einen Bestandteil eines elektro-mechanischen Wandlers des Aktuators bildet, wobei der Wandler konfiguriert ist, in der MEMS-Kapazität gespeicherte elektrische Energie in zumindest eine mechanische Größe zum Antrieb einer Bewegung des Aktuators zu wandeln;
die erste Schalteinrichtung eingerichtet ist, in Abhängigkeit von der Steuerung eine erste Schaltungskonfiguration und sequenziell nachfolgend eine zweite Schaltungskonfiguration einzunehmen, wobei
in der ersten Schaltungskonfiguration ein erster Strompfad durch die Induktivität durchgängig geschaltet ist, um einen von einer Versorgungsspannung (Uv) gespeisten ansteigenden Stromfluss durch die Induktivität (L) zu bewirken, und
in der zweiten Schaltungskonfiguration ein kapazitiv-ungepufferter zweiter Strompfad zwischen einem ersten Pol der Induktivität und der MEMS-Kapazität durchgängig geschaltet ist, um die MEMS-Kapazität mittels eines zumindest anteilig durch die Induktivität gespeisten Stromflusses auf eine erste Spannung aufzuladen, die betragsweise gleich oder höher ist als die Versorgungsspannung (Uv); und **dadurch gekennzeichnet, dass**
die erste Schalteinrichtung des Weiteren eingerichtet ist, wiederholt und jeweils temporär in einem Zeitraum, in dem der zweite Strompfad nicht durchgängig geschaltet ist, einen vierten Strompfad zwischen der MEMS-Kapazität und einem zum dem ersten Pol elektrisch gegenpoligen zweiten Pol der Induktivität derart herzustellen, dass die MEMS-Kapazität dabei auf eine zweite Spannung mit einer zur Polarität der ersten Spannung entgegengesetzten Polarität aufgeladen wird.

2. Schaltung nach Anspruch 1, wobei die Steuerung ungeregelt ist.

3. Schaltung nach einem der vorausgehenden Ansprüche, wobei die erste Schalteinrichtung des Weiteren eingerichtet ist, einen dritten Strompfad wiederholt temporär derart durchgängig zu schalten, dass über diesen dritten Strompfad die MEMS-Kapazität wiederholt, zumindest teilweise entladen werden kann, um an der MEMS-Kapazität eine ihrer Höhe nach zeitlich variable Versorgungsspannung des elektro-mechanischen Wandlers zu erzeugen.

4. Schaltung nach Anspruch 3, wobei der dritte Strompfad zu einer Pufferkapazität zur Pufferung der Versorgungsspannung geführt ist, um Ladung von der MEMS-Kapazität bei deren Entladen in die Pufferkapazität zu überführen.

5. Schaltung einem der vorausgehenden Ansprüche, wobei die Schaltungseinrichtung aufweist:
einen ersten Schalter, S₁, zum Schalten einer elektrischen Verbindung zwischen der Versorgungsspannung und dem zweiten Pol der Induktivität;
einen mit dem ersten Pol der Induktivität elektrisch verbundenen zweiten Schalter, S₂, zum Durchgängigschalten bzw. Unterbrechen des ersten Strompfads;
einen mit dem ersten Pol der Induktivität elektrisch verbundenen dritten Schalter, S₃, zum Durchgängigschalten bzw. Unterbrechen des zweiten Strompfads; und
einen mit dem zweiten Pol der Induktivität und der MEMS-Kapazität elektrisch verbundenen vierten Schalter, S₄, zum Durchgängigschalten bzw. Unterbrechen des vierten Strompfads.

6. Schaltung nach Anspruch 5, des Weiteren aufweisend einen fünften Schalter, S₅, zum Durchgängigschalten bzw. Unterbrechen eines zwischen dem zweiten Pol der Induktivität und Masse liegenden Strompfads.

7. Schaltung nach Anspruch 5 oder 6, wobei die Steuerung konfiguriert ist, die Schaltungseinrichtung schrittweise gemäß der nachfolgenden Sequenz in verschiedene Schaltzustände zu versetzen, wobei die Sequenz wenigstens einmal durchlaufen wird:
(a) S₁ und S₂ geschlossen, S₃ und S₄ offen;
(b) S₁ und S₃ geschlossen, S₂ und S₄ offen;
(c) S₂ und S₃ geschlossen, S₁ und S₄ offen;
(d) S₁ und S₂ geschlossen, S₃ und S₄ offen;
(e) S₂ und S₄ geschlossen, S₁ und S₃ offen;
(f) S₂ und S₃ geschlossen, S₁ und S₄ offen.

8. Schaltung nach Anspruch 7, wobei die Schaltung eine Pufferkapazität, insbesondere einen Kondensator, zur kapazitiven Pufferung der Versorgungsspannung aufweist und die Sequenz zusätzlich einen weiteren Schaltzustand (b1) aufweist, der zwischen den Schaltzuständen (b) und (c) liegt und **dadurch gekennzeichnet ist, dass** in ihm S₁ und S₄ geschlossen und S₂ und S₃ offen sind.

9. Schaltung nach Anspruch 7 oder 8, wobei die Sequenz zusätzlich einen weiteren Schaltzustand (b2) aufweist, der zwischen den Schaltzuständen (b) und (c) liegt, und **dadurch gekennzeichnet ist, dass** in ihm S₂ und S₄ geschlossen und S₁ und S₃ offen sind.

10. Schaltung nach einem der Ansprüche 6 bis 9, wobei die Sequenz zusätzlich einen weiteren Schaltzustand (e1) aufweist, der dem Schaltzustand (e) folgt und dem Schaltzustand (f) vorausgeht und der **dadurch gekennzeichnet ist, dass** in ihm S₄ und S₅ geschlossen und S₁, S₂ und S₃ offen sind.

11. Schaltung nach einem der vorausgehenden Ansprüche, wobei die Steuerung eine mehrstufige Verzögerungskette und einen Multiplexer zum zeitlich gestaffelten Abgreifen der jeweiligen Ausgangssignale der Stufen der Verzögerungskette aufweist, um ein zeitlich variables Steuerungssignal zur Ansteuerung der erste Schalteinrichtung zu erzeugen.

12. Schaltung nach Anspruch 11, wobei die erste Schalteinrichtung mittels des Steuerungssignals derart ansteuerbar ist, dass mittels des Steuerungssignals ein Umschalten zwischen der ersten Schaltkonfiguration und der zweiten Schaltkonfiguration, oder umgekehrt, bewirkt werden kann.

13. Schaltung nach einem der vorausgehenden Ansprüche, des Weiteren aufweisend einen Schwingkreis mit einer Kapazität, die zumindest anteilig durch die MEMS-Kapazität definiert ist, mit einer Schwingkreis-Induktivität und mit einer ansteuerbaren zweite Schalteinrichtung zum selektiven Unterbrechen bzw. Schließen des Schwingkreises in Abhängigkeit von einer Ansteuerung der zweiten Schalteinrichtung;
wobei der Schwingkreis eine auf einen dauerhaft geschlossenen Zustand des Schwingkreises bezogene Resonanzfrequenz aufweist; und
wobei die Steuerung des Weiteren zur Ansteuerung der zweiten Schalteinrichtung derart konfiguriert ist, dass sie die zweite Schalteinrichtung während einer jeweiligen Schwingungsperiode des Schwingkreises temporär für ein bestimmten Anteil der Schwingungsperiode öffnet, um dadurch eine Unterbrechung des Schwingkreises und somit eine tatsächliche Schwingungsfrequenz des Schwingkreises zu bewirken, die kleiner ist als die Resonanzfrequenz.

14. MEMS, aufweisend:
ein schwingungsfähig konfiguriertes Massenelement;
einen Aktuator zum Antrieb einer Schwingungsbewegung des Massenelements; und
eine Schaltung nach einem der vorausgehenden Ansprüche zur Ansteuerung des Aktuators derart, dass dieser dadurch veranlasst wird, das schwingungsfähige Massenelement in einer Schwingungsbewegung zu bewegen;
wobei die MEMS-Kapazität der Schaltung derart als Bestandteil des Aktuators ausgebildet ist, dass sie selbst einen Bestandteil eines elektro-mechanischen Wandlers des Aktuators bildet, und der Wandler konfiguriert ist, in der MEMS-Kapazität gespeicherte elektrische Energie in zumindest eine mechanische Größe zum Antrieb einer Bewegung des Aktuators zu wandeln, um damit die Schwingungsbewegung des Massenelements anzutreiben.

15. MEMS, nach Anspruch 14, wobei das MEMS ein Mikroscannersystem aufweist; und das Massenelement als schwingungsfähig konfiguriertes Ablenkelement des Mikroscannersystems zum Ablenken von elektromagnetischer Strahlung ausgebildet ist.

## Claims

1. Circuit for driving an actuator for driving an oscillatory movement of at least one movable component of a microelectromechanical system, MEMS, wherein:
the circuit has a boost converter circuit (200) with an inductance (L), an electrical MEMS capacitance (CM) and a first switching device which can be driven by means of a controller;
the MEMS capacitance is designed as a component of an actuator in such a way that it forms a component of an electromechanical transducer of the actuator,
wherein the transducer is configured to convert electrical energy stored in the MEMS capacitance into at least one mechanical variable for driving a movement of the actuator;
the first switching device is set up to assume a first circuit configuration as a function of the controller and to sequentially subsequently assume a second circuit configuration, wherein
in the first circuit configuration, a first current path is connected continuously through the inductance in order to bring about an increasing current flow through the inductance (L), said current flow being fed by a supply voltage (Uv), and
in the second circuit configuration, a capacitively unbuffered second current path is connected continuously between a first pole of the inductance and the MEMS capacitance in order to charge the MEMS capacitance by means of a current flow fed at least proportionally through the inductance to a first voltage which is in terms of absolute value equal to or higher than the supply voltage (Uv); and
**characterized in that** the first switching device is furthermore set up to repeatedly and in each case temporarily establish, in a time period in which the second current path is not connected continuously, a fourth current path between the MEMS capacitance and a second pole of the inductance, said second pole being electrically opposite to the first pole, in such a way that the MEMS capacitance is in this case charged to a second voltage with a polarity opposite to the polarity of the first voltage.

2. Circuit according to Claim 1, wherein the controller is unregulated.

3. Circuit according to one of the preceding claims, wherein the first switching device is furthermore set up to repeatedly and temporarily connect continuously a third current path in such a way that the MEMS capacitance can be repeatedly, at least partially discharged via this third current path in order to generate a supply voltage of the electromechanical transducer, said supply voltage being variable in terms of its level over time at the MEMS capacitance.

4. Circuit according to Claim 3, wherein the third current path is led to a buffer capacitance for buffering the supply voltage in order to transfer charge from the MEMS capacitance into the buffer capacitance during the discharging thereof.

5. Circuit according to one of the preceding claims, wherein the circuit device comprises:
a first switch, S₁, for switching an electrical connection between the supply voltage and the second pole of the inductance;
a second switch, S₂, which is electrically connected to the first pole of the inductance, for connecting or interrupting the first current path;
a third switch, S₃, which is electrically connected to the first pole of the inductance, for connecting or interrupting the second current path; and
a fourth switch, S₄, which is electrically connected to the second pole of the inductance and the MEMS capacitance, for connecting or interrupting the fourth current path.

6. Circuit according to Claim 5, furthermore comprising a fifth switch, S₅, for connecting or interrupting a current path which lies between the second pole of the inductance and ground.

7. Circuit according to Claim 5 or 6, wherein the controller is configured to set the circuit device stepwise into different switching states according to the following sequence, wherein the sequence is run through at least once:
(a) S₁ and S₂ closed, S₃ and S₄ open;
(b) S₁ and S₃ closed, S₂ and S₄ open;
(c) S₂ and S₃ closed, S₁ and S₄ open;
(d) S₁ and S₂ closed, S₃ and S₄ open;
(e) S₂ and S₄ closed, S₁ and S₃ open;
(f) S₂ and S₃ closed, S₁ and S₄ open.

8. Circuit according to Claim 7, wherein the circuit comprises a buffer capacitance, in particular a capacitor, for capacitive buffering of the supply voltage and the sequence additionally comprises a further switching state (b1) which lies between the switching states (b) and (c) and is **characterized in that** S₁ and S₄ are closed and S₂ and S₃ are open in said further switching state (b1).

9. Circuit according to Claim 7 or 8, wherein the sequence additionally comprises a further switching state (b2) which lies between the switching states (b) and (c) and is **characterized in that** S₂ and S₄ are closed and S₁ and S₃ are open in said further switching state (b2).

10. Circuit according to one of Claims 6 to 9, wherein the sequence additionally comprises a further switching state (e1) which follows the switching state (e) and precedes the switching state (f) and is **characterized in that** S4 and S5 are closed and S1, S2 and S3 are open in said further switching state (e1).

11. Circuit according to one of the preceding claims, wherein the controller has a multistage delay chain and a multiplexer for the time-staggered tapping of the respective output signals of the stages of the delay chain in order to generate a time-variable control signal for driving the first switching device.

12. Circuit according to Claim 11, wherein the first switching device can be driven by means of the control signal in such a way that switching between the first switching configuration and the second switching configuration, or vice versa, can be brought about by means of the control signal.

13. Circuit according to one of the preceding claims, furthermore comprising an oscillating circuit with a capacitance which is defined at least in part by the MEMS capacitance, with an oscillating circuit inductance and with a drivable second switching device for selectively interrupting or closing the oscillating circuit as a function of driving the second switching device;
wherein the oscillating circuit has a resonant frequency related to a permanently closed state of the oscillating circuit; and
wherein the controller is furthermore configured for driving the second switching device in such a way that it opens the second switching device temporarily for a certain portion of the oscillation period during a respective oscillation period of the oscillating circuit in order thereby to bring about an interruption of the oscillating circuit and thus an actual oscillation frequency of the oscillating circuit which is lower than the resonant frequency.

14. MEMS, comprising:
a mass element configured to be capable of oscillation;
an actuator for driving an oscillatory movement of the mass element; and
a circuit according to one of the preceding claims for driving the actuator in such a way that it is thereby caused to move the mass element capable of oscillation in an oscillatory movement;
wherein the MEMS capacitance of the circuit is designed as a component of the actuator in such a way that it itself forms a component of an electromechanical transducer of the actuator, and the transducer is configured to convert electrical energy stored in the MEMS capacitance into at least one mechanical variable for driving a movement of the actuator, in order to thereby drive the oscillatory movement of the mass element.

15. MEMS according to Claim 14, wherein the MEMS comprises a microscanner system; and the mass element is designed as a deflection element of the microscanner system configured to be capable of oscillation for deflecting electromagnetic radiation.

## Revendications

1. Circuit de commande d'un actionneur pour l'entraînement d'un mouvement oscillant d'au moins un composant mobile d'un système micro-électromécanique, MEMS, dans lequel :
le circuit présente un circuit convertisseur élévateur (200) avec une inductance (L), une capacité MEMS électrique (CM) et un premier dispositif de commutation pouvant être commandé au moyen d'une commande ;
la capacité MEMS est réalisée en tant que composant d'un actionneur de telle sorte qu'elle forme un composant d'un convertisseur électromécanique de l'actionneur, dans lequel le convertisseur est configuré pour convertir l'énergie électrique accumulée dans la capacité MEMS en au moins une grandeur mécanique pour l'entraînement d'un mouvement de l'actionneur ;
le premier dispositif de commutation est conçu pour adopter, en fonction de la commande, une première configuration de circuit et, séquentiellement par la suite, une deuxième configuration de circuit, dans lequel
dans la première configuration de circuit, un premier trajet de courant est connecté en continu à travers l'inductance, afin de provoquer un flux de courant croissant alimenté par une tension d'alimentation (Uv) à travers l'inductance (L), et
dans la deuxième configuration de circuit, un deuxième trajet de courant non tamponné capacitivement est connecté en continu entre un premier pôle de l'inductance et la capacité MEMS, afin de charger la capacité MEMS au moyen d'un flux de courant alimenté au moins en partie par l'inductance à une première tension qui est en valeur absolue égale ou supérieure à la tension d'alimentation (Uv) ; et
**caractérisé en ce que** le premier dispositif de commutation est en outre conçu pour établir de manière répétée et à chaque fois temporairement dans un laps de temps dans lequel le deuxième trajet de courant n'est pas connecté en continu, un quatrième trajet de courant entre la capacité MEMS et un deuxième pôle de l'inductance de polarité opposée électriquement au premier pôle, de telle sorte que la capacité MEMS soit chargée à cet effet à une deuxième tension avec une polarité opposée à la polarité de la première tension.

2. Circuit selon la revendication 1, dans lequel la commande n'est pas régulée.

3. Circuit selon l'une quelconque des revendications précédentes, dans lequel le premier dispositif de commutation est en outre conçu pour commuter de manière répétée temporairement en continu un troisième trajet de courant de telle sorte que la capacité MEMS puisse être déchargée de manière répétée, au moins en partie, par le biais de ce troisième trajet de courant, afin de générer au niveau de la capacité MEMS une tension d'alimentation du convertisseur électromécanique variable dans le temps en fonction de sa hauteur.

4. Circuit selon la revendication 3, dans lequel le troisième trajet de courant est guidé vers une capacité tampon pour le tamponnage de la tension d'alimentation, afin de transférer la charge de la capacité MEMS lors de sa décharge dans la capacité tampon.

5. Circuit selon l'une quelconque des revendications précédentes, dans lequel le dispositif de commutation présente :
un premier commutateur, S₁, pour commuter une liaison électrique entre la tension d'alimentation et le deuxième pôle de l'inductance ;
un deuxième commutateur, S₂, connecté électriquement au premier pôle de l'inductance, pour la connexion continue ou l'interruption du premier trajet de courant ;
un troisième commutateur, S₃, connecté électriquement au premier pôle de l'inductance, pour la connexion continue ou l'interruption du deuxième trajet de courant ; et
un quatrième commutateur, S₄, connecté électriquement au deuxième pôle de l'inductance et à la capacité MEMS, pour la connexion continue ou l'interruption du quatrième trajet de courant.

6. Circuit selon la revendication 5, présentant en outre un cinquième commutateur, S₅, pour la connexion continue ou l'interruption d'un trajet de courant situé entre le deuxième pôle de l'inductance et la masse.

7. Circuit selon la revendication 5 ou 6, dans lequel la commande est configurée pour amener le dispositif de commutation pas à pas selon la séquence suivante dans différents états de commutation, dans lequel la séquence est parcourue au moins une fois :
(a) S₁ et S₂ sont fermés, S₃ et S₄ sont ouverts ;
(b) S₁ et S₃ sont fermés, S₂ et S₄ sont ouverts ;
(c) S₂ et S₃ sont fermés, S₁ et S₄ sont ouverts ;
(d) S₁ et S₂ sont fermés, S₃ et S₄ sont ouverts ;
(e) S₂ et S₄ sont fermés, S₁ et S₃ sont ouverts ;
(f) S₂ et S₃ sont fermés, S₁ et S₄ sont ouverts.

8. Circuit selon la revendication 7, dans lequel le circuit présente une capacité tampon, en particulier un condensateur, pour le tamponnage capacitif de la tension d'alimentation et la séquence présente en outre un autre état de commutation (b1), qui se situe entre les états de commutation (b) et (c) et est **caractérisé en ce que** S₁ et S₄ sont fermés et S₂ et S₃ sont ouverts.

9. Circuit selon la revendication 7 ou 8, dans lequel la séquence présente en outre un autre état de commutation (b2), qui se situe entre les états de commutation (b) et (c) et est **caractérisé en ce que** S₂ et S₄ sont fermés et S₁ et S₃ sont ouverts.

10. Circuit selon l'une quelconque des revendications 6 à 9, dans lequel la séquence présente en outre un autre état de commutation (e1), qui suit l'état de commutation (e) et précède l'état de commutation (f) et est **caractérisé en ce que** S₄ et S₅ sont fermés et S_{1,} S₂ et S₃ sont ouverts.

11. Circuit selon l'une quelconque des revendications précédentes, dans lequel la commande présente une chaîne de retard à plusieurs étages et un multiplexeur pour le prélèvement échelonné dans le temps des signaux de sortie respectifs des étages de la chaîne de retard, afin de générer un signal de commande variable dans le temps pour la commande du premier dispositif de commutation.

12. Circuit selon la revendication 11, dans lequel le premier dispositif de commutation peut être commandé au moyen du signal de commande de telle sorte qu'une commutation entre la première configuration de commutation et la deuxième configuration de commutation, ou inversement, puisse être provoquée au moyen du signal de commande.

13. Circuit selon l'une quelconque des revendications précédentes, présentant en outre un circuit oscillant avec une capacité qui est définie au moins en partie par la capacité MEMS, avec une inductance de circuit oscillant et avec un deuxième dispositif de commutation pouvant être commandé pour l'interruption ou la fermeture sélective du circuit oscillant en fonction d'une commande du deuxième dispositif de commutation ;
dans lequel le circuit oscillant présente une fréquence de résonance liée à un état fermé en permanence du circuit oscillant ; et
dans lequel la commande est en outre configurée pour la commande du deuxième dispositif de commutation de telle sorte qu'elle ouvre temporairement le deuxième dispositif de commutation pendant une période d'oscillation respective du circuit oscillant pendant une partie déterminée de la période d'oscillation, afin de provoquer ainsi une interruption du circuit oscillant et ainsi une fréquence d'oscillation réelle du circuit oscillant qui est inférieure à la fréquence de résonance.

14. MEMS, présentant :
un élément de masse configuré de manière à pouvoir osciller ;
un actionneur pour l'entraînement d'un mouvement oscillant de l'élément de masse ; et
un circuit selon l'une quelconque des revendications précédentes pour la commande de l'actionneur de telle sorte qu'il soit ainsi amené à déplacer l'élément de masse pouvant osciller dans un mouvement oscillant ;
dans lequel la capacité MEMS du circuit est réalisée en tant que composant de l'actionneur de telle sorte qu'elle forme elle-même un composant d'un convertisseur électromécanique de l'actionneur, et le convertisseur est configuré pour convertir l'énergie électrique accumulée dans la capacité MEMS en au moins une grandeur mécanique pour l'entraînement d'un mouvement de l'actionneur, pour ainsi entraîner le mouvement oscillant de l'élément de masse.

15. MEMS selon la revendication 14, dans lequel le MEMS présente un système de micro-balayage ; et l'élément de masse est réalisé en tant qu'élément de déviation configuré de manière à pouvoir osciller du système de micro-balayage pour dévier un rayonnement électromagnétique.
